# EUROPEAN PATENT SPECIFICATION

(11) **EP 1 050 963 B1**
(45) Date of publication and mention of the grant of the patent: **14.03.2007**
(21) Application number: 99972385.1
(22) Date of filing: 11.11.1999
(51) Int. Cl.: H03J 7/18, H04N 5/44

(54) **RECEIVER FOR DIGITAL TERRESTRIAL BROADCASTING**
EMPFÄNGER FÜR DIGITALE TERRESTRISCHE FERNSEHÜBERTRAGUNG
RECEPTEUR POUR LA RADIODIFFUSION NUMERIQUE TERRESTRE

(30) Priority: 12.11.1998 JP 32179598
(43) Date of publication of application: 08.11.2000
(73) Proprietor: MATSUSHITA ELECTRIC INDUSTRIAL CO., LTD., Kadoma-shi, Osaka 571-8501 (JP)
(72) Inventor: AZAKAMI, Hiroshi, Osaka 576-0054 (JP); SERITA, Masashi Room 401 Palace Momoyamadai, Toyonaka-shi Osaka 567-0085 (JP); KONISHI, Takaaki, Ibaraki-shi Osaka 567-0861 (JP)
(74) Representative: Lang, Johannes
(86) International application number: PCT/JP1999/006266
(87) International publication number: WO 2000/030254

(56) References cited:
- EP-A- 0 683 576
- EP-A- 0 869 648
- JP-A- 9 312 550
- JP-A- 10 511 256
- JP-A- 11 055 079
- JP-A- 11 298 298
- US-A- 5 313 169

## Description

In the conventional analog terrestrial broadcasting wave, each channel has one normal frequency assigned, and thus an analog terrestrial broadcasting wave receiver applies a one-channel-one-frequency mode therein. Accordingly, when a channel is selected, a frequency assigned thereto is also selected, and thus channel selection is securely done. When a frequency drift occurres, the terrestrial broadcasting wave receiver utilizes its automatic frequency tuning to carry out channel selection correctly, although it takes longer.

In the digital terrestrial broadcasting wave, on the other hand, three frequencies including a normal (or centre) frequency, an upper-offset frequency, and a lower-offset frequency are possibilities to be singularly assigned to one channel. Such frequency assignment is varied depending on an area. Therefore, each digital broadcast station determines which frequency goes to which channel.

In a transition period of terrestrial broadcasting wave from analog to digital, an analog broadcast channel may be observed adjacent to a digital broadcast channel in some areas. If this is the case, radio waves on the digital broadcast channel and those on the adjacent analog broadcast channel may interfere with each other. To avoid such interference, when assigning a frequency to the digital broadcast channel out of three possible frequencies, the digital broadcast stations need to take the adjacent analog broadcast channel into consideration.

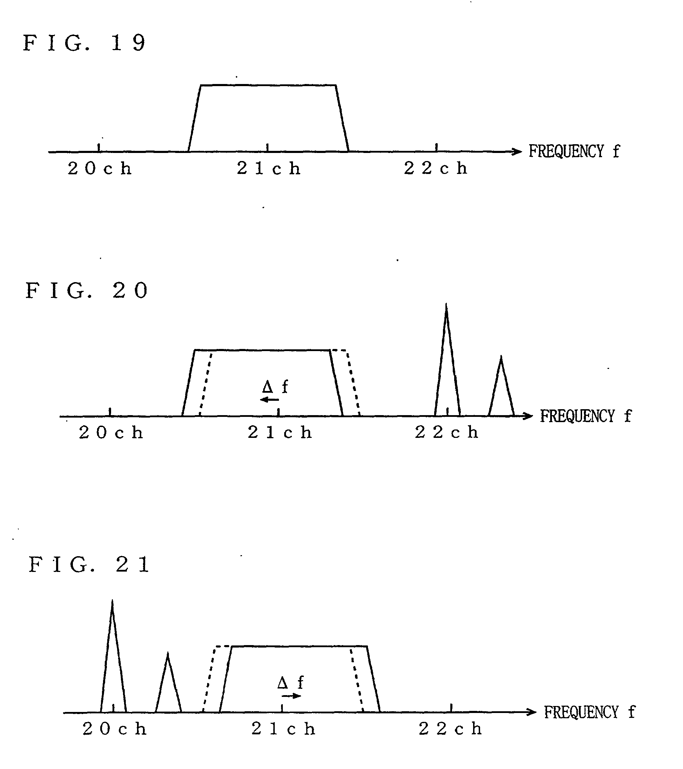

It is now assumed that a digital broadcast station has a 21ch assigned thereto (herein, a channel having a channel number N is referred to as "Nch", the same is applicable to the below). As exemplarily shown in FIG. 19, if neither of adjacent 20ch nor 22ch is the analog broadcast channel in an area where the broadcast station belongs, the broadcast station uses the centre frequency of the 21ch as the frequency for digital broadcast. Contrarily, as exemplarily shown in FIG. 20, if the upper-adjacent 22ch is the analog broadcast channel but the 21ch being the digital broadcast channel with the centre frequency assigned (i.e., if a frequency band denoted by a dotted line in FIG. 20 is used for digital broadcast) in the area where the broadcast station belongs, the radio waves on the digital broadcast channel and those on the analog broadcast channel 22ch may interfere with each other. In such case, the broadcast station uses the lower-offset frequency of the 21ch as the frequency for digital broadcast. Further, as shown in FIG. 21, if the lower-adjacent 20ch is the analog broadcast channel but the 21ch being the digital broadcast channel with the centre frequency assigned (i.e., if a frequency band denoted by a dotted line in FIG. 21 is used for digital broadcast), the radio waves from the digital broadcast channel and those from the analog broadcast channel 20ch may interfere with each other. Therefore, the broadcast station uses the upper-offset frequency of the 21ch as the frequency for digital broadcast.

So far, no interference in radio waves has been observed for an analog broadcast channel adjacent to the terrestrial wave digital broadcast channel.

This is the reason why the conventional digital terrestrial broadcasting wave receiver has been structured to select only one frequency for one channel. Resultantly, the conventional digital terrestrial broadcasting wave receiver may leave some channel incapably unselected.

The terrestrial broadcasting wave receiver is generally provided with a function (preset function) of searching a broadcast frequency for every digital-broadcast-receivable channel, and storing a result obtained thereby. In the case that the digital terrestrial broadcasting wave receiver is provided with such preset function, in a transition period of terrestrial broadcasting wave from analog to digital, after preset, some new digital broadcast channel may be provided, some broadcast channel may be changed from analog to digital, or some digital broadcast channel may be changed in frequency (e.g., changed from the normal frequency to the lower-offset frequency). In such case, the digital terrestrial broadcasting wave receiver cannot receive digital broadcast from such new channel or channels subjected to the above-described changes.

US Patent 5584051 discloses an analog and/or digital radio broadcast transmission system and radio receiver therefor, which includes a control signal having an item of control information concerning another different type of transmission/receiver system. The receiver is a hybrid receiver able to receive both types of signals. When the same program material is available on both of the different systems, the control signal is used for switching the different systems so that the receiver receives the program on the system which provides the best reception.

Therefore, an object of the present invention is to provide a digital terrestrial broadcasting wave receiver being freed from the above-described problems occurring in the transition period of terrestrial broadcasting wave from analog to digital while receiving digital broadcast assuredly on a channel on request. In detail, an object of the present invention is to provide a digital terrestrial broadcasting wave receiver receiving digital broadcast assuredly from a channel on request while taking three possible frequencies to be singularly assigned to one channel into consideration. Another object of the present invention is to provide a digital terrestrial broadcasting wave receiver which can receive digital broadcast from, after preset for channels, a digital broadcast channel newly provided, a broadcast channel changed from analog to digital, or a digital broadcast channel changed in frequency.

### DISCLOSURE OF THE INVENTION

A first aspect of the present invention is directed to a digital terrestrial broadcasting wave receiver of a type receiving digital-modulated digital terrestrial wave signals by an antenna, and extracting thereamong, for demodulation, one digital terrestrial wave signal corresponding to a digital broadcast channel specified by a user, the receiver comprises:
channel selection means for outputting, when the user specifies a requested channel for reception through a user's operation in a predetermined manner, channel specifying information indicating the requested channel;
channel initial data storage means for previously storing three possible frequencies including a centre frequency, an upper-offset frequency, and a lower-offset frequency assigned to each of a plurality of predetermined digital broadcast channels;
a front end part for receiving a control signal which instructs a channel selection procedure with any one of the three possible frequencies assigned to the requested channel, carrying out, based on the control signal, extraction and demodulation operations with respect to the digital terrestrial wave signals received by the antenna, and generating synchronization confirmation information indicating whether or not the selection operation is completed successfully; and
control means for generating the control signal according to the channel specifying information, and controlling the front end part by supplying the generated control signal to the front end part, wherein
the control means
   includes single channel selection search means for generating the control signal according to the three possible frequencies assigned to one channel in the channel initial data storage means, and searching for a broadcast frequency in actual use for digital broadcast among the three possible frequencies assigned to the one channel, based on the synchronization confirmation information obtained by supplying the generated control signal to the front end part, and
determines the broadcast frequency of the requested channel by the single-channel selection search means

In the first aspect, channel selection is carried out with consideration for three possible frequencies being previously assigned to one channel for digital broadcast. In detail, the frequency in actual use for digital broadcast is searched for among the three possible frequencies assigned to the requested channel. Therefore, digital broadcast is assuredly received on the requested channel.

According to a second aspect of the present invention, in the first aspect,
the digital terrestrial broadcasting wave receiver further comprises rewritable nonvolatile storage means for storing a frequency in use for digital broadcast for any one of the predetermined digital broadcast channels in conjunction with each of the channels, wherein
the control means
further includes storage judgement means for judging whether or not the broadcast frequency for digital broadcast on the requested channel is stored in the nonvolatile storage means,
when the storage judgement means judges that the broadcast frequency of the requested channel is stored in the nonvolatile storage means, supplies, to the front end part, the control signal instructing the channel selection procedure with the stored broadcast frequency, and
when the storage judgement means does not judge that the broadcast frequency of the requested channel is stored in the nonvolatile storage means has the single-channel selection search means search for the broadcast frequency of the requested channel, supplies, to the front end part, the control signal instructing the channel selection procedure with the broadcast frequency of the requested channel and stores the broadcast frequency obtained by the search into the nonvolatile storage means in conjunction with the requested channel.

In the second aspect, with the search for the broadcast frequency of the requested channel, the frequency, among the three possible frequencies assigned to the channel, in actual use for digital broadcast, i.e., the broadcast frequency of the channel, is stored into the nonvolatile storage means. Therefore, when the channel is again specified by the user as the requested channel, the front end part can start channel selection operation with the already-stored frequency as the broadcast frequency of the requested channel. In this manner, a time taken from specification of the requested channel to completion of channel selection can be shorter. Further, similarly to the first aspect, digital broadcast can be assuredly received on the requested channel with consideration for the three possible frequencies assigned to every channel.

According to a third aspect of the present invention, in the second aspect,
after generating the control signal instructing the channel selection operation with the frequency stored in the nonvolatile storage means as the broadcast frequency of the requested channel for output to the front end part, when the channel selection procedure is not successfully completed, the control means supplies the control signal instructing the channel selection procedure with the broadcast frequency of the requested channel by having the single-channel selection search means search for the broadcast frequency of the requested channel, and updates the broadcast frequency stored in the nonvolatile storage means in conjunction with the requested channel to the broadcast frequency obtained by the search.

In the third aspect, if the front end part cannot complete its channel selection procedure successfully after a channel selection operation carried out with the frequency stored as the broadcast frequency of the requested channel, the broadcast frequency of the requested channel is searched for by the single channel selection search means, the channel selection operation is carried out with the searched broadcast frequency, and then the frequency stored as the broadcast frequency of the requested channel is updated to the searched broadcast frequency. In this manner, even if some digital broadcast channel is changed in frequency, digital broadcast can be received on the channel.

A fourth aspect of the present invention is directed to a digital terrestrial broadcasting wave receiver of a type receiving digital-modulated digital terrestrial wave signals by an antenna, and extracting thereamong, for demodulation, one digital terrestrial wave signal corresponding to a digital broadcast channel specified by a user, the receiver comprises:
channel selection means for outputting, when the user specifies a requested channel for reception through his/her operation in a predetermined manner, channel specifying information indicating the requested channel;
all-channel scan means for receiving a predetermined preset instruction, and in response thereto, sequentially outputting, on a channel basis, channel specifying information which specifies each of a plurality of predetermined digital broadcast channels;
channel initial data storage means for previously storing three possible frequencies of a centre frequency, an upper-offset frequency, and a lower-offset frequency assigned to each of the predetermined digital broadcast channels;
rewritable nonvolatile storage means for storing a frequency in use for digital broadcast on each of the predetermined digital broadcast channels in conjunction with the channels;
a front end part receiving a control signal which instructs a channel selection procedure with any one of the three possible frequencies assigned to one channel, carrying out, based on the control signal, extraction and demodulation operations with respect to the digital terrestrial wave signals received by the antenna, and generating synchronization confirmation information indicating whether or not the channel selection operation is completed successfully; and
control means for controlling the front end part by generating the control signal according to the channel specifying information outputted from the channel selection means or the all-channel scan means and by supplying the generated control signal to the front end part, wherein
the control means,
   includes all-channel selection search means for generating, when the all-channel scan means receives the preset instruction, the control signal according to the three possible frequencies, stored in the channel initial data storage means, being assigned to a specified channel specified by each of the channel specifying information sequentially outputted from the all-channel scan means, searching for a broadcast frequency in actual use for digital broadcast among the three possible frequencies assigned to the specified channel, based on the synchronization confirmation information obtained by supplying the generated control signal to the front end part, and storing the broadcast frequency obtained by the search into the nonvolatile storage means in conjunction with the specified channel, and
   when the channel specifying information is outputted from the channel selection means, reads the broadcast frequency stored in the nonvolatile storage means in conjunction with the requested channel, and then generates the control signal instructing the channel selection operation with the read frequency for output to the front end part.

In the fourth aspect, with a preset instruction, the broadcast frequency is searched for every predetermined channel by the all-channel selection search means with consideration for three possible frequencies to be singularly assigned to one channel for digital broadcast into consideration. Therefore, every predetermined channel can be assuredly searched for the broadcast frequency thereof. Further, once the preset is carried out, as long as the predetermined channels are the digital broadcast channels, the broadcast frequencies thereof are stored in the nonvolatile storage means. Therefore, in the case that the predetermined channels are the digital-broadcast-receivable channels, once the preset is carried out, digital broadcast can be received on the requested channel by first reading the broadcast frequency of the requested channel from the nonvolatile storage means, and then starting the front end part for channel selection.

According to a fifth aspect of the present invention, in the fourth aspect,
the control means
further includes single-channel selection search means for searching for, based on the synchronization confirmation information obtained by first generating the control signal according to the three possible frequencies assigned to one channel in the channel initial data storage means and then by supplying the generated control signal to the front end part, the broadcast frequency in actual use for digital broadcast among the three possible frequencies assigned to the one channel, and
storage judgement means for judging whether or not the broadcast frequency for digital broadcast on the requested channel is stored in the nonvolatile storage means, and
when the storage judgement means judges that the broadcast frequency of the requested channel is stored in the nonvolatile storage means, supplies the control signal instructing the channel selection procedure with the stored broadcast frequency to the front end part, and
when the storage judgement means does not judge that the broadcast frequency of the requested channel is stored in the nonvolatile storage means, has the single-channel selection search means search the broadcast frequency of the requested channel, supplies the control signal instructing the channel selection procedure with the broadcast frequency of the requested channel to the front end part, and stores the broadcast frequency obtained by the search into the nonvolatile storage means in conjunction with the requested channel.

In the fifth aspect, when the broadcast frequency of the requested channel is not stored, the broadcast frequency is searched for by the single-channel selection search means. Therefore, even if some digital broadcast channel is newly provided after preset, digital broadcast can be received thereon. Further, the broadcast frequency obtained by the search is stored in the nonvolatile storage means. In this manner, when the channel is again specified as the requested channel, the broadcast frequency is read from the nonvolatile storage means, and thus channel selection can be immediately started.

According to a sixth aspect of the present invention, in the fourth aspect,
the control means
further includes single-channel selection search means for generating the control signal according to the three possible frequencies assigned to one channel in the channel initial data storage means, and searching for a broadcast frequency in actual use for digital broadcast among the three possible frequencies assigned to the one channel, based on the synchronization confirmation information obtained by and by supplying, the generated control signal to the front end part, and
after generating the control signal instructing the channel selection procedure with the frequency stored in the nonvolatile storage means as the broadcast frequency of the requested channel for output to the front end part, when the channel selection operation is not completed successfully, has the single channel selection search means search for the broadcast frequency of the requested channel, supplies the control signal instructing the channel selection procedure with the broadcast frequency of the requested channel to the front end part, and updates the broadcast frequency stored in the nonvolatile storage means in conjunction with the requested channel to the broadcast frequency obtained by the search.

In the sixth aspect, if the front end part cannot complete its channel selection successfully after a channel selection operation carried out with the frequency stored as the broadcast frequency of the requested channel, the broadcast frequency of the requested channel is searched for by the single-channel selection search means. Therefore, even if some digital broadcast channel is changed in frequency after preset, digital broadcast can be received thereon. Further, the broadcast frequency of the channel stored in the nonvolatile storage means is updated to the broadcast frequency obtained by the search. In this manner, when the channel is again specified as the requested channel, channel selection can be immediately started by reading the broadcast frequency from the nonvolatile storage means.

According to a seventh aspect of the present invention, in the fourth aspect,
the digital terrestrial broadcasting wave receiver further comprises all-channel search instruction means for providing the preset instruction to the all-channel scan means in response to a user's operation.

In the seventh aspect, in the case that some digital broadcast channel is newly provided or changed in arrangement, the all-channel scan means is provided with a preset instruction through operation on the all-channel search instruction means. With the all-channel search means, the frequency of the newly-provided or arrangement-changed digital broadcast channel is stored into the nonvolatile storage means in conjunction with each channel. In this manner, even if some digital broadcast channel is newly provided or changed in arrangement, digital broadcast can be received thereon.

According to an eighth aspect of the present invention, in the fourth aspect,
the digital terrestrial broadcasting wave receiver further comprises timer means for outputting a signal providing the preset instruction to the all-channel scan means at a predetermined time interval.

In the eighth aspect, the timer means outputs a signal providing the preset instruction to the all-channel scan means at a predetermined time interval. Therefore, even if some digital broadcast channel is newly provided or changed in arrangement, digital broadcast can be received thereon at least after a predetermined period.

According to a ninth aspect of the present invention, in the fourth aspect,
the digital terrestrial broadcasting wave receiver further comprises reception means for receiving information transmitted through a predetermined transmission path, and when the received information indicates any digital broadcast channel being newly provided or changed in arrangement, providing the preset instruction to the all-channel scan means.

In the ninth aspect, when the reception means receives information indicating that some digital broadcast channel is newly provided or changed in arrangement, the all-channel scan means is provided with the preset instruction. Therefore, even if some digital broadcast channel is newly provided or changed in arrangement, digital broadcast can be received thereon.

According to a tenth aspect of the present invention, in the fourth aspect,
the digital terrestrial broadcasting wave receiver further comprises reception means for receiving information transmitted through a predetermined transmission path, and when the received information includes identifying information of the digital broadcast channel in current use, outputting the identifying information, and
the control means
further includes single-channel selection search means for generating the control signal according to the three possible frequencies assigned to one channel in the channel initial data storage means, and searching for a broadcast frequency in actual use for digital broadcast among the three possible frequencies assigned to the one channel based on the synchronization confirmation information obtained by and by supplying the generated control signal to the front end part, and
when the identification information is outputted from the reception means, determines the broadcast frequency of the channel identified by the identifying information by the single-channel selection search means, and then stores the determined broadcast frequency into the nonvolatile storage means in conjunction with the channel identified by the identifying information.

In the tenth aspect, when the information received by the reception means includes specifying information about the digital broadcast channel in current use, the broadcast frequency of the channel is searched for by the single-channel selection search means, and the result obtained thereby is stored. In this manner, even if some digital broadcast channel is newly provided or changed in arrangement, after the above information including the identifying information about these channels is received, digital broadcast can be received thereon .

According to a eleventh aspect of the present invention, in the fourth aspect,
the digital terrestrial broadcasting wave receiver further comprises reception means for receiving information transmitted through a predetermined transmission path, and when the received information includes the identifying information and the broadcast frequency of the digital broadcast channel in current use, outputting the identifying information and the broadcast frequency, wherein
when the identifying information and the broadcast frequency are outputted from the reception means, the control means stores the broadcast frequency outputted from the reception means into the nonvolatile storage means in conjunction with the channel identified by the identifying information.

In the eleventh aspect, when the information received by the reception means includes the specifying information and the broadcast frequency of the digital broadcast channel in current use, the broadcast frequency is stored in conjunction with the channel. In this manner, even if some digital broadcast channel is newly provided or changed in arrangement, after the above information including the identifying information and the broadcast frequency of the channel is received, digital broadcast can be received thereon.

According to a twelfth aspect of the present invention, in the first or fourth aspect,
the digital terrestrial wave signals are OFDM modulated signals, and
the front end part
includes OFDM demodulation means for demodulating the digital terrestrial wave signals, and
generates an OFDM synchronizing signal as the synchronization confirmation information when the OFDM demodulation means correctly demodulates the digital terrestrial wave signals.

According to a thirteenth aspect of the present invention, in the first or fourth aspect,
the digital terrestrial wave signals are OFDM modulated signals, and
the front end part includes
OFDM demodulation means for demodulating the digital terrestrial wave signals, and
voltage controlled oscillating means for generating a system clock for the OFDM demodulation means, and
the synchronization confirmation information is a signal indicating a control voltage to be supplied to the voltage controlled oscillating means.

According to a fourteenth aspect of the present invention, in the first or fourth aspect,
the digital terrestrial wave signals are OFDM modulated signals, and
the front end part includes
OFDM demodulation means for demodulating the digital terrestrial wave signals, and
error correction means for correcting an error included in a signal, if any, obtained by the demodulation carried out by the OFDM demodulation means with respect to the digital terrestrial wave signals, and
the synchronization confirmation information is BER measurement information generated by the error correction means.

According to a fifteenth aspect of the present invention, in the first aspect,
the single-channel selection search means searches for the centre frequency with a higher priority among the three possible frequencies.

According to a sixteenth aspect of the present invention, in the fourth aspect,
the all-channel selection search means searches for the centre frequency with a higher priority among the three possible frequencies.

According to a seventeenth aspect of the present invention, in the fifth or sixth aspect,
the all-channel selection search means searches for the centre frequency with a higher priority among the three possible frequencies, and
the single-channel selection search means searches the centre frequency with a higher priority among the three possible frequencies.

In the fifteenth, sixteenth, and seventeenth aspects, when the single-channel selection means and the all-channel selection means perform search, the centre frequency has a higher priority, for the search, among the three possible frequencies assigned to one channel. In detail, the front end part carries out the channel selection first with the centre frequency generally having a higher possibility for use than the upper-offset frequency or the lower-offset frequency. Therefore, according to the fifteenth, sixteenth, and seventeenth aspects, a time taken from specification of the requested channel to completion of channel selection or a time for preset can be averagely shorter.

According to an eighteenth aspect of the present invention, in the first, fifth, or sixth aspect,
the single-channel selection search means includes
first synchronization confirmation means for judging, based on the synchronization confirmation information obtained by supplying, to the front end part, the control signal instructing a channel selection procedure with a first frequency included in the three possible frequencies assigned to the one channel, whether or not the channel selection operation with the first frequency is completed successfully, and
second synchronization confirmation means for judging, when the channel selection procedure with the first frequency is not judged as being completed successfully, based on the synchronization confirmation information obtained by supplying, to the front end part, the control signal instructing a channel selection procedure with a second frequency included in the three possible frequencies assigned to the one channel but not the first frequency, whether or not the channel selection operation with the second frequency is completed successfully, wherein
when the channel selection procedure with the first frequency is judged as being completed successfully, the first frequency is determined as the broadcast frequency of the one channel, when the channel selection procedure with the second frequency is judged as being completed successfully, the second frequency is determined as the broadcast frequency of the one channel, and when neither of the channel selection procedures with the first nor second frequencies is judged as being completed successfully, a third frequency included in the three possible frequencies assigned to the one channel but not the first or the second frequency is determined as the broadcast frequency of the one channel.

According to a nineteenth aspect of the present invention, in the first, fifth, or sixth aspect,
the single-channel selection search means includes:
first synchronization confirmation means for judging, based on the synchronization confirmation information obtained by supplying, to the front end part, the control signal instructing a channel selection procedure with a first frequency which is any one of the three possible frequencies assigned to the one channel, whether or not the channel selection procedure with the first frequency is completed successfully;
second synchronization confirmation means for judging, when the channel selection procedure with the first frequency is not judged as being completed successfully, based on the synchronization confirmation information obtained by supplying, to the front end part, the control signal instructing a channel selection procedure with a second frequency included in the three possible frequencies assigned to the one channel but not the first frequency, whether or not the channel selection procedure with the second frequency is completed successfully, and
third synchronization confirmation means for judging, when neither of the channel selection procedures with the first nor second frequencies is not judged as being completed successfully based on the synchronization confirmation information obtained by supplying, to the front end part, the control signal instructing a channel selection procedure with a third frequency included in the three possible frequencies assigned to the one channel but not the first or second frequency, whether or not the channel selection procedure with the third frequency is completed successfully, wherein
when the channel selection procedure with the first frequency is judged as being completed successfully, the first frequency is determined as the broadcast frequency of the one channel, when the channel selection procedure with the second frequency is judged as being completed successfully, the second frequency is determined as the broadcast frequency of the one channel, and when the channel selection procedure with the third frequency is judged as being completed successfully the third frequency is determined as the broadcast frequency of the one channel.

According to a twentieth aspect of the present invention, in the fourth, fifth, or sixth aspect,
the all-channel selection search means includes:
first synchronization confirmation means for judging, based on the synchronization confirmation information obtained by supplying, to the front end part, the control signal instructing a channel selection procedure with a first frequency which is any one of the three possible frequencies assigned to the specified channel, whether or not the channel selection procedure with the first frequency is completed successfully;
second synchronization confirmation means for judging, when the channel selection operation with the first frequency is not judged as being completed successfully, based on the synchronization confirmation information obtained by supplying, to the front end part, the control signal instructing a channel selection procedure with a second frequency included in the three possible frequencies assigned to the specified channel but not the first frequency, whether or not the channel selection procedure with the second frequency is completed successfully and
third synchronization confirmation means for judging, when neither of the channel selection procedures with the first nor second frequencies is not judged as being completed successfully based on the synchronization confirmation information obtained by supplying, to the front end part, the control signal instructing a channel selection procedure with a third frequency included in the three possible frequencies assigned to the specified channel but not the first or second frequency, whether or not the channel selection procedure with the third frequency is completed successfully, wherein
when the channel selection procedure with the first frequency is judged as being completed successfully, the first frequency is stored into the nonvolatile storage means as the broadcast frequency of the specified channel, when the channel selection procedure with the second frequency is judged as being completed successfully, the second frequency is stored into the nonvolatile storage means as the broadcast frequency of the specified channel, and when the channel selection procedure with the third frequency is judged as being completed successfully the third frequency is stored into the nonvolatile storage means as the broadcast frequency of the specified channel.

A twenty-first aspect of the present invention is directed to a reception channel selection method to be applied to a digital terrestrial broadcasting wave receiver of a type receiving digital-modulated digital terrestrial wave signals by an antenna, and extracting thereamong, for demodulation, one digital terrestrial wave signal corresponding to a digital broadcast channel specified by a user, the method comprises:
a channel initial data storing step of previously storing three possible frequencies including a centre frequency, an upper-offset frequency, and a lower-offset frequency assigned to every predetermined digital broadcast channel;
a channel specifying step of outputting, when the user specifies a requested channel for reception through a user's operation in a predetermined manner, channel specifying information indicating the requested channel;
a control signal generating step of generating, based on the three possible frequencies assigned to the requested channel in the channel initial data storing step, a control signal which instructs a channel selection operation with any one of the three possible frequencies assigned to the requested channel;
a synchronization confirmation information generating step of carrying out, based on the generated control signal, extraction and demodulation operations with respect to the digital terrestrial wave signals received by the antenna, and generating synchronization confirmation information indicating whether or not the channel selection procedure including the extraction and demodulation operations is completed successfully and
a search step of searching for, based on the synchronization confirmation information, a broadcast frequency in actual use for digital broadcast among the three possible frequencies assigned to the requested channel.

A twenty-second aspect of the present invention is directed to reception channel selection method to be applied to a digital terrestrial broadcasting wave receiver of a type receiving digital-modulated digital terrestrial wave signals by an antenna, and extracting thereamong, for demodulation, one digital terrestrial wave signal corresponding to a digital broadcast channel specified by a user, the method comprises:
a channel initial data storing step of previously storing three possible frequencies including a centre frequency, an upper-offset frequency, and a lower-offset frequency assigned to every predetermined digital broadcast channel;
an all-channel scan step of receiving a predetermined preset instruction, and in response thereto, sequentially outputting, on a channel basis, channel specifying information which specifies each of a plurality of predetermined digital broadcast channels;
a first control signal generating step of generating, on reception of the preset instruction, based on the previously stored three possible frequencies assigned to a specified channel specified by each of the channel specifying information sequentially outputted, a control signal instructing a channel selection procedure with any one of the three possible frequencies;
a synchronization confirmation information generating step of carrying out, based on the control signal generated in the first control signal generating step, extraction and demodulation operations with respect to the digital terrestrial wave signals received by the antenna, and generating synchronization confirmation information indicating whether or not the channel selection procedure including the extraction and demodulation operations are completed successfully;
a search step of searching for, based on the synchronization confirmation information, a broadcast frequency in actual use for digital broadcast among the three possible frequencies assigned to the specified channel;
a storage step of storing the broadcast frequency obtained in the search step into predetermined nonvolatile storage means in conjunction with the specified channel;
a channel specifying step of outputting channel specifying information indicating a requested channel in response to the user's requested channel for reception through the user's operation in a predetermined manner;
a reading step of reading the broadcast frequency stored in the nonvolatile storage means in conjunction with the requested channel when the channel specifying information is outputted in the channel specifying step;
a second control signal generating step of generating a control signal instructing a channel selection with the frequency read from the nonvolatile storage means; and
a channel selection procedure step of carrying out extraction and demodulation operations with respect to the digital terrestrial wave signals received by the antenna based on the control signal generated in the second control signal generating step.

### BRIEF DESCRIPTION OF THE DRAWINGS

FIG. 1 is a block diagram showing the structure of a digital terrestrial broadcasting wave receiver according to a first embodiment of the present invention;
FIG. 2 is a block diagram showing a first exemplary structure of a front end part provided in the digital terrestrial broadcasting wave receiver of the first embodiment;
FIG. 3 is a block diagram showing a second exemplary structure of the front end part provided in the digital terrestrial broadcasting wave receiver of the first embodiment;
FIG. 4 is a block diagram showing a third exemplary structure of the front end part provided in the digital terrestrial broadcasting wave receiver according to the first embodiment;
FIG. 5 is a flowchart showing how the digital terrestrial broadcasting wave receiver of the first embodiment carries out channel selection;
FIG. 6 is a block diagram showing the structure of a digital terrestrial broadcasting wave receiver according to a second embodiment of the present invention;
FIG. 7 is a flowchart showing how the digital terrestrial broadcasting wave receiver of the second embodiment carries out channel selection;
FIG. 8 is a flowchart showing a procedure for a single channel selection search in the digital terrestrial broadcasting wave receiver of the second embodiment;
FIG. 9 is a block diagram showing the structure of a digital terrestrial broadcasting wave receiver according to a third embodiment of the present invention;
FIG. 10 is an exemplary flowchart showing how the digital terrestrial broadcasting wave receiver of the third embodiment carries out channel selection;
FIG. 11 is a flowchart showing a procedure for every channel selection search in the digital terrestrial broadcasting wave receiver of the third embodiment;
FIG. 12 is a block diagram showing the structure of a digital terrestrial broadcasting wave receiver according to a fourth embodiment of the present invention;
FIG. 13 is a flowchart showing a procedure for a preset carried out in the digital terrestrial broadcasting wave receiver of the fourth embodiment;
FIG. 14 is a flowchart showing a first examplary processing carried out to deal with an addition of a new digital broadcast channel or a change of channel arrangement in the digital terrestrial broadcasting wave receiver of the fourth embodiment;
FIG. 15 is a flowchart showing a second examplary processing carried out to deal with an addition of a new digital broadcast channel or a change of channel arrangement in the digital terrestrial broadcasting wave receiver of the fourth embodiment;
FIG. 16 is a flowchart showing a third examplary processing carried out to deal with an addition of a new digital broadcast channel or a change of channel arrangement in the digital terrestrial broadcasting wave receiver of the fourth embodiment;
FIG. 17 is a block diagram showing the structure of a digital terrestrial broadcasting wave receiver according to a fifth embodiment of the present invention;
FIG. 18 is a flowchart showing an examplary processing carried out to deal with an addition of a new digital broadcast channel or a change of channel arrangement in the digital terrestrial broadcasting wave receiver of the fifth embodiment;
FIG. 19 is a diagram showing frequency assignment for digital broadcast in the case that an adjacent channel is not an analog broadcast channel;
FIG. 20 is a diagram showing frequency assignment for digital broadcast in the case that an upper adjacent channel is the analog broadcast channel; and
FIG. 21 is a diagram showing frequency assignment for digital broadcast in the case that a lower adjacent channel is the analog broadcast channel.

### BEST MODE FOR CARRYING OUT THE INVENTION

In order to describe the present invention to a greater detail, the description is made by referring to the accompanying drawings.

### <1. First Embodiment>

### <1.1 Structure of First Embodiment>

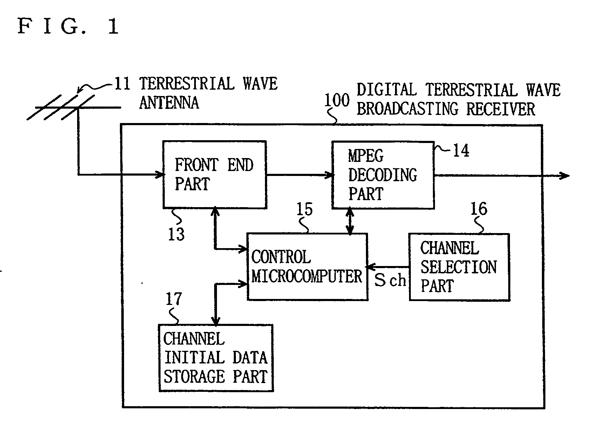

Depicted in FIG. 1 is a block diagram showing the structure of a digital terrestrial broadcasting wave receiver 100 according to a first embodiment of the present invention. The digital terrestrial broadcasting wave receiver 100 is provided with a terrestrial broadcasting wave antenna 11, a front end part 13, an MPEG decoding part 14, a control microcomputer 15, a channel selection part 16, and a channel initial data storage part 17. Thereamong, the control microcomputer 15 is the one which controls other constituents in the digital terrestrial broadcasting wave receiver 100, and operates in a later-described manner by carrying out a predetermined program stored in internally-provided memory (this is applicable also to other embodiments). In other words, the control microcomputer 15 is a constituent mainly performing later-described channel selection, for example, and is operationally realized by software.

The terrestrial broadcasting wave antenna 11 receives an OFDM (Orthogonal Frequency Division Multiplex) modulated signal, which is a digital terrestrial wave signal transmitted from a broadcast station. The received OFDM signal is forwarded to the front end part 13. The channel selection part 16 responds to a user's operation, and outputs a signal specifying a user's requested channel (hereinafter, referred to as "channel specifying signal") Sch. The channel specifying signal Sch is provided to the control microcomputer 15. The channel initial data storage part 17 prestores data, as initial data, which indicates three types of frequencies including the normal (or centre) frequency, the upper-offset frequency, and the lower-offset frequency for each of the channels selectable by the channel selection part 16. Based on the channel specifying signal Sch, the control microcomputer 15 reads, from the channel initial data storage part 17, at least one data (hereinafter, "requested channel frequency data") indicating the normal (or centre) frequency, the upper-offset frequency, or the lower-offset frequency for the user's requested channel (referred also simply as "requested channel"). Thereafter, the control microcomputer 15 controls the front end part 13 based both on the requested channel frequency data and a later-described signal provided by the front end part 13 for synchronization confirmation. Under the control of the control microcomputer 15, the front end part 13 subjects the OFDM modulated signal provided by the terrestrial broadcasting wave antenna 11 to digital demodulation so as to correct any error generated in a transmission path (hereinafter, such operation is referred to as "channel selection procedure by the front end part 13", details of which are later described). In this manner, a transport stream signal on the user's requested channel is obtained, and then is forwarded to the MPEG decoding part 14. This transport stream signal is image data encoded under the MPEG scheme. The MPEG decoding part 14 generates decoded image data (data of MPEG image) from the transport stream signal for external output.

### <1.2 Structure of Front End Part and Channel Selection Operation Thereby>

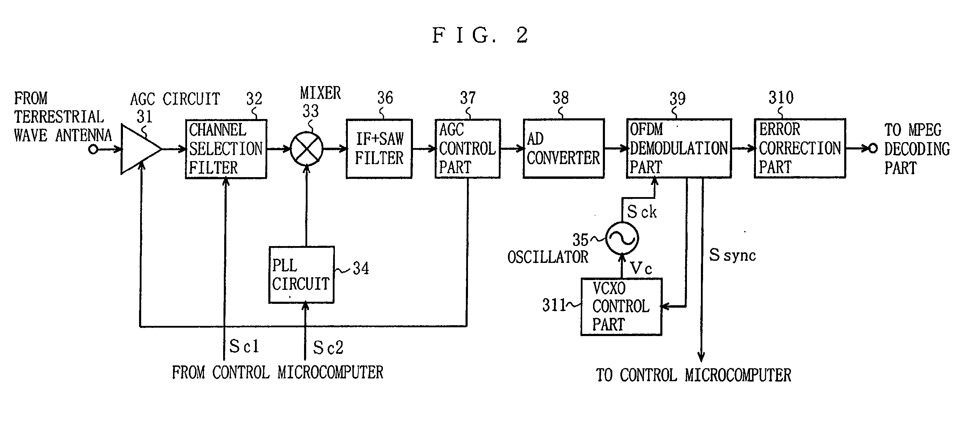

Depicted in FIG. 2 is a block diagram showing a first exemplary structure of the front end part 13. The front end part 13 in such structure is provided with an AGC circuit 31, a channel selection filter 32, a mixer 33, a PLL synchronization circuit 34, an IF+SAW filter 36, an AGC control part 37, an AD converter 38, an oscillator 35, a VCXO control part 311, an OFDM demodulation part 39, and an error correction part 310.

The front end part 13 in such structure is supplied with control signals Sc1 and Sc2 on the basis of the requested channel frequency data from the control microcomputer 15. In response to the control signal Sc2, the PLL synchronization circuit 34 operates, and then channel selection is started. The OFDM modulated signal provided from the terrestrial broadcasting wave antenna 11 to the front end part 13 is controlled first by the AGC circuit 31 so as to be in a power level appropriate for a digital demodulation system in stages subsequent thereto. To be specific, the AGC control part 37 generates a control signal based on an output from the IF+SAW filter which is later-described, and based thereon, the AGC circuit 31 controls a gain thereof. In this manner, the OFDM modulated signal is controlled to be in a power level appropriate for the subsequent digital demodulation system. Thereafter, the OFDM signal is forwarded to the channel election filter 32.

The selection filter 32 functions, based on the control signal Sc1 from the control microcomputer 15, as a band-pass filter passing only a signal in a frequency band corresponding to the requested channel frequency data. Therefore, with the channel selection filter 32, a signal (hereinafter, referred to as "requested signal") having a frequency (hereinafter, referred to as "channel selection frequency") indicated by the requested channel frequency data is extracted from the above OFDM modulated signal. The extracted requested signal is mixed with an oscillation signal, which is generated by the PLL synchronization circuit and is in the channel selection frequency, and then down-converted into a frequency band of an IF signal (intermediate frequency signal). The down-converted requested signal is wave-shaped by going through the IF+SAW filter 36, converted from analog to digital in the AD converter 38, and then outputted to the subsequent OFDM demodulation part 39.

The OFDM demodulation part 39 operates on a system clock Sck supplied from the oscillator 35. The oscillator 35 is a voltage controlled crystal oscillator (VCXO), and a control voltage Vc thereof is generated by the VCXO control part 311 based on a signal outputted from the OFDM demodulation part 39. When the requested channel is correctly selected, the VCXO control part 311 and the oscillator 35 generating the system clock Sck to be provided to the OFDM demodulation part 39 operate successfully, and thus the OFDM demodulation part 39 can correctly carry out digital demodulation. Accordingly, an error generated in the transmission path, if any, can be corrected by the error correction part 310. The error-corrected signal is forwarded to the MPEG decoding part 14 as the transport stream signal on the requested channel.

When the front end part 13 operates in the above-described successful manner, the OFDM demodulation part 39 outputs an OFDM synchronizing signal Ssync. The OFDM synchronizing signal Ssync is forwarded to the control microcomputer 15 as information for synchronization confirmation. With the OFDM synchronizing signal Ssync, the control microcomputer 15 judges that synchronization has been confirmed, i.e., the front end part 13 has normally (or successfully) completed its channel selection procedure. If the requested channel is not correctly selected, the OFDM synchronizing signal Ssync is not forwarded to the control microcomputer 15. Consequently, the control microcomputer 15 judges that synchronization is not yet confirmed, i.e., the front end part 13 does not yet complete its channel selection operation.

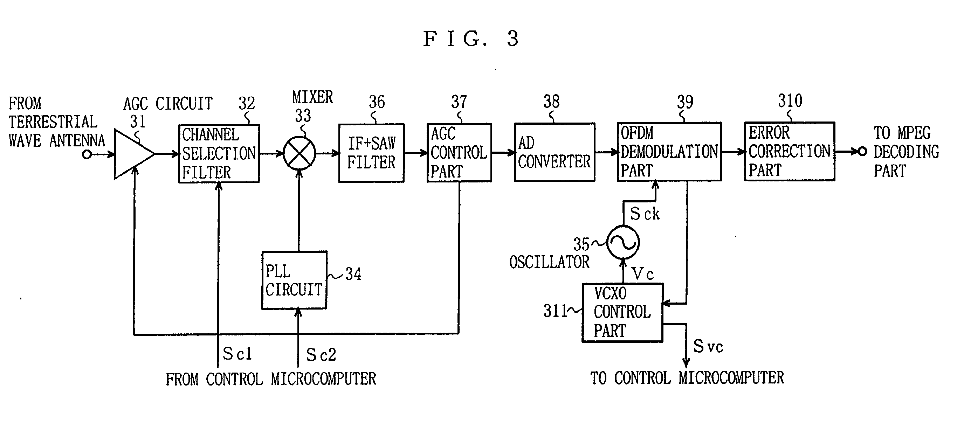

Depicted in FIG. 3 is a block diagram showing a second exemplary structure of the front end part 13. The front end part 13 in such structure forwards a signal (hereinafter, referred to as "control voltage signal") Svc to the control microcomputer 15 as information for synchronization confirmation. The signal Svc indicates the control voltage Vc of the oscillator 35 which supplies the system clock Sck to the OFDM demodulation part 39. This is the difference from the first exemplary structure in which the OFDM synchronizing signal Ssync is forwarded to the control microcomputer 15 as information for synchronization confirmation. Other than that, the second exemplary structure is similar to the first, thus the same components share the same reference numerals, and are not described again.

In the front end part 13 in the second exemplary structure, when the requested channel is correctly selected on the basis of the control signals Sc1 and Sc2 (i.e. information corresponding to the requested channel frequency) provided by the control microcomputer 15, the VCXO control part 311 which generates the system clock Sck to be provided to the OFDM demodulation part 38 operates in an appropriate range, and thus the control voltage Vc of the oscillator 35 does not vary. Therefore, in this exemplary structure, as described above, the control voltage signal Svc indicating the control voltage Vc is forwarded to the control microcomputer 15 as information for synchronization confirmation. Based on this control voltage signal Svc, the control microcomputer 15 checks whether or not the control voltage Vc varies (to be specific, regards as not varying if the variation of the control voltage Vc stays for a predetermined duration of time within a predetermined range). If the control voltage Vc is regarded as not varying, the control microcomputer 15 judges that synchronization has been confirmed, i.e., the front end part 13 has successfully completed its channel selection procedure. If the control voltage Vc is regarded as varying, on the other hand, the control microcomputer 15 judges that synchronization is not yet confirmed, i.e, the front end part 13 does not yet complete its channel selection operation.

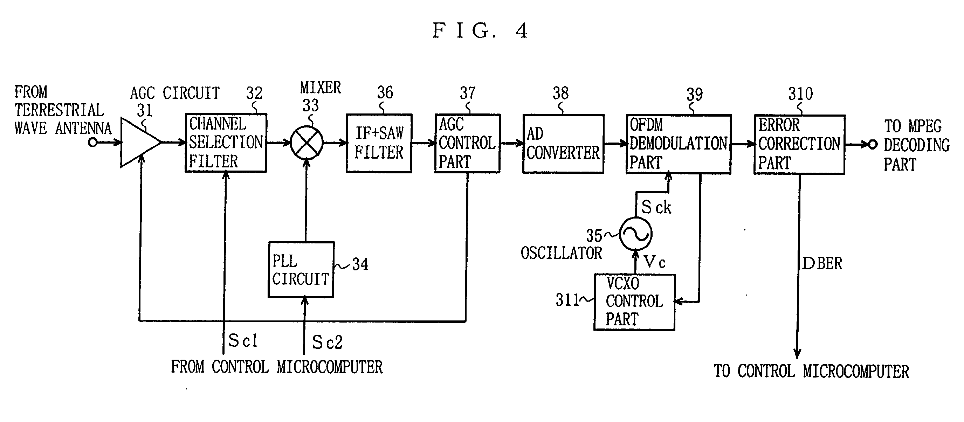

Depicted in FIG. 4 is a block diagram showing a third exemplary structure of the front end part 13. The front end part 13 in this structure forwards, to the control microcomputer 15 as information for synchronization confirmation, a signal indicating BER (Bit Error Rate) measurement information DBER obtained by the error correction part 310. This is the difference from the first exemplary structure in which the OFDM synchronizing signal Ssync is forwarded to the control microcomputer 15 as information for synchronization confirmation. Other than that, the third exemplary structure is similar to the first, thus the same components share the same reference numerals, and are not described again.

In the front end part 13 in the third exemplary structure, when the requested channel is correctly selected on the basis of the control signals Sc1 and Sc2 (i.e., information corresponding to the requested channel frequency) provided by the control microcomputer 15, a bit error rate (BER) measured by the error correction part 310 becomes "0". Therefore, in this exemplary structure, as described above, the signal indicating the BER measurement information DBER is forwarded to the control microcomputer 15 as information for synchronization confirmation. Based on the BER measurement information DBER, when BER = 0, the control microcomputer 15 judges that synchronization has been confirmed, i.e., the front end part 13 has normally completed its channel selection operation. When BER ≠ 0, on the other hand, the control microcomputer 15 judges that synchronization is not yet confirmed, i.e., the front end part 13 does not yet complete its channel selection operation.

Herein, in the third exemplary structure, the value of BER is stored in a predetermined register provided in the error correction part 310. Further, as already described, the control microcomputer 15 carrying out channel selection is operationally realized by software. Accordingly, in a respect that synchronization is confirmable by referring to the predetermined register, the third exemplary structure shows a better match for channel selection mainly realized by software.

### <1.3 Channel Selection in First Embodiment>

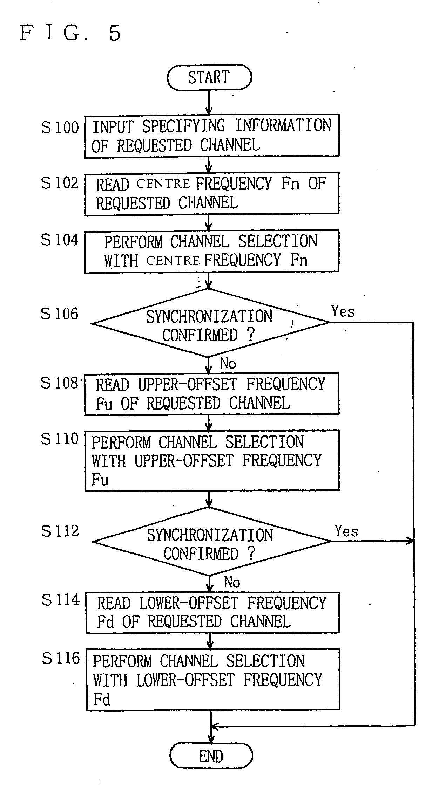

Next, with reference to FIG. 5, it is described how the digital terrestrial broadcasting wave receiver of the first embodiment carries out channel selection. As described above, although synchronization confirmation is varied in means depending on the structure of the front end part 13, any exemplary structure from first to third in the foregoing may basically lead to the same manner for channel selection described below (the same is applicable to channel selection in other embodiments).

After the user operates the channel selection part 16 and specifies a channel (requested channel) for reception, the channel specifying signal Sch is provided, as information specifying the requested channel, from the channel selection part 16 to the control microcomputer 15 (step S100). With the channel specifying signal Sch, the control microcomputer 15 operates as follows: first reads a normal (or centre) frequency Fn of the requested channel indicated by the channel specifying signal Sch from the channel initial data storage part 17 (step S102); secondly generates the control signals Sc1 and Sc2 on the basis of the normal (or centre) frequency Fn, and then supplies the generated control signals Sc1 and Sc2 to the front end part 13 so as to cause the front end part 13 to carry out channel selection operation with the normal frequency Fn (step S104); and lastly receives the information for synchronization confirmation (OFDM synchronizing signal Ssync, the control voltage signal Svc, or the signal indicating the BER measurement information DBER) from the front end part 13, and based thereon, judges whether or not synchronization has been confirmed in the above-described manner (step S106). If synchronization is confirmed through the judgement, the control microcomputer 15 ends its channel selection.

If synchronization is not judged as being confirmed in step S106, the control microcomputer 15 operates as follows: first reads an upper-offset frequency Fu of the above requested channel from the channel initial data storage part 17 (step S108); secondly generates the control signals Sc1 and Sc2 on the basis of the upper-offset frequency Fu, and then supplies the generated control signals Sc1 and Sc2 to the front end part 13 so as to cause the front end part 13 to carry out channel selection operation with the upper-offset frequency Fu (step S110); and lastly receives the information for synchronization confirmation (OFDM synchronizing signal Ssync, the control voltage signal Svc, or the signal indicating the BER measurement information DBER) from the front end part 13, and based thereon, judges whether or not synchronization has been confirmed in the above-described manner (step S112). If synchronization is confirmed through the judgement, the control microcomputer 15 ends its channel selection.

If synchronization is not judged as being confirmed in step S112, the control microcomputer 15 operates as follows: first reads a lower-offset frequency Fd of the above requested channel from the channel initial data storage part 17 (step S114); secondly generates the control signals Sc1 and Sc2 on the basis of the lower-offset frequency Fd, and then supplies the generated control signals Sc1 and Sc2 to the front end part 13 so as to cause the front end part 13 to carry out channel selection operation with the lower-offset frequency Fd (step S116). If the requested channel is a digital broadcast channel, the control microcomputer 15 now ends its channel selection. As a result, the transport stream signal of the requested channel is outputted from the front end part 13, and then decoded by the MPEG decoding part 14.

Also in the case that synchronization is confirmed either in step S106 or S112, the transport stream signal of the requested channel is outputted from the front end part 13, and then decoded by the MPEG decoding part 14.

Herein, in the above-described procedure for channel selection in FIG. 5, with the requested channel specified, its channel selection is first carried out with the normal (or centre) frequency of the requested channel. If synchronization is not confirmed thereby, then the upper-offset frequency of the requested channel is used for its channel selection. If synchronization is not yet confirmed thereby, the lower-offset frequency of the requested channel is used for channel selection. In other words, in the above procedure for channel selection, priorities are set for searching the broadcast frequency of the requested channel in such order as normal (or centre) frequency→upper-offset frequency→lower-offset frequency. In the present invention, however, the order is not restrictive and may be in order of normal (or centre) frequency→lower-offset frequency→upper-offset frequency, or in some other orders for searching the broadcast frequency. In the case that the channel adjoining to the requested channel is not the analog broadcast channel, the requested channel is usually assigned the normal (or centre) frequency for digital broadcast. Accordingly, the normal (or centre) frequency generally has a higher possibility for use than the upper-offset frequency or the lower-offset frequency. Therefore, it is preferable to set the highest priority to the normal frequency among the three possible frequencies assigned to the requested channel. That is, for the search of the broadcast frequency for the requested channel, it is preferable to carry out channel selection firstly with the normal (or centre) frequency. In this manner, a time taken for channel selection is averagely reduced. <1.4 Effects of First Embodiment>

As described in the foregoing, according to the first embodiment, channel selection is carried out with consideration for three possible frequencies being previously assigned to one channel for digital broadcast (see FIG. 5), whereby digital broadcast is assuredly received on the requested channel. In detail, even if the requested channel is not assigned, as the frequency for digital broadcast, the normal (or centre) frequency but the upper-offset frequency or the lower-offset frequency, digital broadcast can be assuredly received thereon.

### <2. Second Embodiment>

### <2.1 Structure of Second Embodiment>

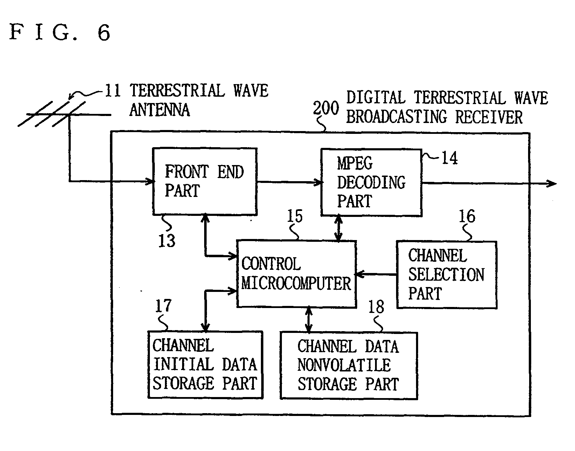

Depicted in FIG. 6 is a block diagram showing the structure of a digital terrestrial broadcasting wave receiver 2000 according to a second embodiment of the present invention. The digital terrestrial broadcasting wave receiver 200 is provided with a channel data nonvolatile storage part 18. In this respect, the digital terrestrial broadcasting wave receiver 200 differs from the digital terrestrial broadcasting wave receiver 100 of the first embodiment depicted in FIG. 1. The channel data nonvolatile storage part 18 is implemented by nonvolatile memory, and is used to store a frequency obtained by searching for the digital broadcast frequency for the requested channel. Constituents other than the channel data nonvolatile storage part 18 herein are the same as those in the first embodiment, thus are under the same reference numerals and not described again.

### <2.2 Channel Selection in Second Embodiment>

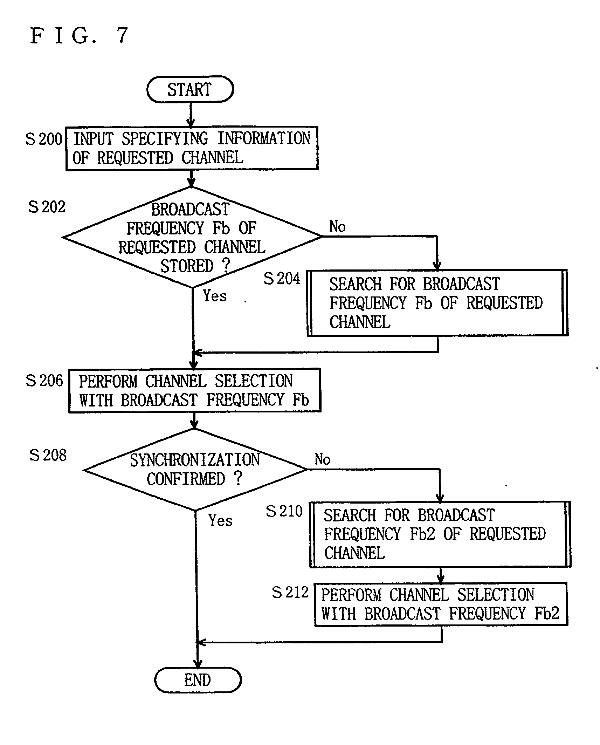

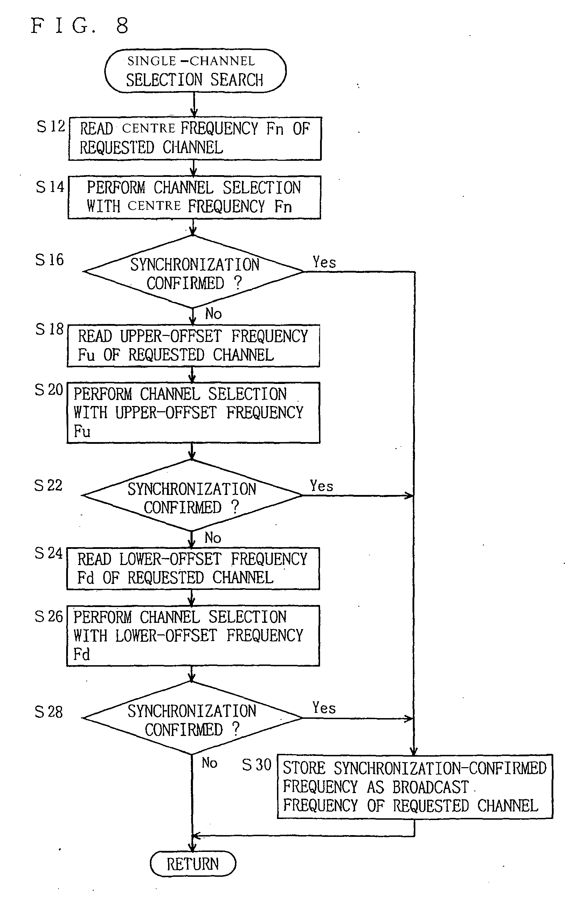

By referring to FIGS. 7 and 8, it is described next below how the digital terrestrial broadcasting wave receiver of the second embodiment carries out channel selection.

After the user operates the channel selection part 16 and specifies a channel (requested channel) for reception, the channel specifying signal Sch is provided, as information for specifying the requested channel, from the channel selection part 16 to the control microcomputer 15 (step S200). With the channel specifying signal Sch, the control microcomputer 15 operates as follows.

First, the control microcomputer 15 checks whether or not the channel data nonvolatile storage part 18 stores a frequency (broadcast frequency) Fb for digital broadcast of the requested channel indicated by the channel specifying signal Sch (step S202). If the broadcast frequency of the requested channel is judged as being stored, the procedure goes to step S206. If the broadcast frequency Fb of the requested channel is not judged as being stored, the broadcast frequency of the requested channel is determined by carrying out a single-channel selection search (details thereof are later described), the procedure of which is shown in FIG. 8 (step S204). Note that, the single-channel selection search is carried out when the requested channel in the digital terrestrial broadcasting wave receiver has not yet been through the single-channel selection search. As is described later, after the single-channel selection search, the broadcast frequency of the requested channel, that is, the result obtained by the search is stored in the channel data nonvolatile storage part 18 as long as the requested channel is a digital broadcast channel.

In step S206, the control microcomputer 15 generates, as the broadcast frequency of the requested channel, the control signals Sc1 and Sc2 on the basis of the frequency Fb stored in the channel data nonvolatile storage part 18, and then outputs the generated control signals Sc1 and Sc2 to the front end part 13 so as to cause the front end part 13 to carry out channel selection operation with the broadcast frequency Fb. Thereafter, the control microcomputer 15 receives the information for synchronization confirmation (OFDM synchronizing signal Ssync, the control voltage signal Svc, or the signal indicating the BER measurement information DBER) from the front end part 13, and based thereon, judges whether or not synchronization has been confirmed (step S208). If synchronization is confirmed through the judgement, the control microcomputer 15 ends its channel selection in a normal (or successful) manner.

If synchronization is not judged as being confirmed in step S208, the procedure goes to step S210. This may be the case when the broadcast frequency of the requested channel which has been stored in the channel nonvolatile storage part 18 after the single-channel selection search is changed, for example, from the normal (or centre) frequency to the upper-offset frequency.

In step S210, the broadcast frequency of the requested channel is determined through the single-channel selection search shown in FIG. 8 (step S210). Thereafter, the control microcomputer 15 generates the control signals Sc1 and Sc2 on the basis of a broadcast frequency Fb2 stored in the channel data nonvolatile storage part 18 as the frequency obtained by the search, and outputs the generated control signals Sc1 and Sc2 to the front end part 13 so as to cause the front end part 13 to carry out channel selection operation with the broadcast frequency Fb2 (step S212). Thereafter, the control microcomputer 15 ends its channel selection.

Referring to FIG. 8, it is described the procedure for the single-channel selection search carried out in steps S204 and S212.

In the single-channel selection search, the normal (or centre) frequency Fn of the requested channel is read from the channel initial data storage part 17 (step S12). Then, the control signals Sc1 and Sc2 are generated on the basis of the normal (or centre) frequency Fn, and then the generated control signals Sc1 and Sc2 are outputted to the front end part 13 so as to cause the front end part 13 to perform channel selection operation with the normal (or centre) frequency Fn (step S14). Thereafter, the information for synchronization confirmation (OFDM synchronizing signal Ssync, the control voltage signal Svc, or the signal indicating the BER measurement information DBER) is received from the front end part 13, and based thereon, it is then determined whether or not synchronization has been confirmed (step S16). If synchronization is confirmed through the judgement, the synchronization-confirmed frequency, that is, the normal (or centre) frequency Fn, is stored into the channel data nonvolatile storage part 18 as the broadcast frequency of the requested channel (step S30), and the single-channel selection search is ended.

If synchronization is not judged as being confirmed in step S16, the upper-offset frequency Fu of the requested channel is read from the channel initial data storage part 17 (step S18). Next, on the basis of the upper-offset frequency Fu, the control signals Sc1 and Sc2 are generated and outputted to the front end part 13 so as to cause the front end part 13 to carry out channel selection operation with the upper-offset frequency Fu (step S20). Thereafter, the information for synchronization confirmation (OFDM synchronizing signal Ssync, the control voltage signal Svc, or the signal indicating the BER measurement information DBER) is received from the front end part 13, and based thereon, it is then judged whether or not synchronization has been confirmed (step S22). If synchronization is confirmed through the judgement, the synchronization-confirmed frequency, that is, the upper-offset frequency Fu, is stored into the channel data nonvolatile storage part 18 as the broadcast frequency of the requested channel (step S30), and the single-channel selection search is ended.

If synchronization is not judged as being confirmed in step S22, the lower-offset frequency Fd of the requested channel is read from the channel initial data storage part 17 (step S24). Next, the control signals Sc1 and Sc2 are generated on the basis of the lower-offset frequency Fd, and then the generated control signals Sc1 and Sc2 are outputted to the front end part 13 so as to cause the front end part 13 to carry out channel selection operation with the lower-offset frequency Fd (step S26). Thereafter, information for synchronization confirmation is received from the front end part 13, and based thereon, it is then judged whether or not synchronization has been confirmed (step S28). If synchronization is confirmed through the judgement, the synchronization-confirmed frequency, that is, the lower-offset frequency Fd, is stored in the channel data nonvolatile storage part 18 as the broadcast frequency of the requested channel (step S30), and the single-channel selection search is ended. If synchronization is not confirmed through the judgement, on the other hand, it means that the user's requested channel is not a digital broadcast channel. If this is the case, the single channel selection search is ended without the lower-offset frequency being stored into the channel data nonvolatile storage part 18.

After the single-channel selections search carried out in the above-described manner, the broadcast frequency of the requested channel is stored in the channel data nonvolatile storage part 18 as long as the requested channel is a digital broadcast channel.

### <2.3 Effects of Second Embodiment>

According to the above-described second embodiment, with the broadcast frequency of the requested channel searched (single channel selection search), among three possible frequencies assigned to the channel, a frequency in actual use for digital broadcast, i.e., the broadcast frequency of the channel, is stored in the channel data nonvolatile storage part 18 (step S30 in FIG. 8). Therefore, when the channel is again specified by the user as the requested channel, the control microcomputer 15 has the front end part 13 start channel selection operation with the already-stored frequency as the broadcast frequency of the requested channel (steps S202 and S206 in FIG. 7). In this manner, a time taken from specification of the requested channel to completion of channel selection can be shorter than the first embodiment. Further, similarly to the first embodiment, digital broadcast can be assuredly received on the requested channel while taking the three possible frequencies assigned to every channel into consideration.

Further, according to the second embodiment, if synchronization is not confirmed by channel selection carried out with the frequency stored as the broadcast frequency of the requested channel, the single-channel selection search is carried out to newly search for the broadcast frequency of the requested channel (step S210 in FIG. 7, and FIG. 8). Thus, channel selection is carried out with the broadcast frequency determined thereby (step S212 in FIG 7). As is known from this, even if a digital broadcast channel is changed in frequency (e.g., from the normal (or centre) frequency to the upper-offset frequency) and thus the broadcast frequency stored in the channel data nonvolatile storage part 18 is not the broadcast frequency in actual use any more, the broadcast frequency in storage is updated so that digital broadcast can be received on the channel.

### <3. Third Embodiment>

### <3.1 Structure of Third Embodiment>

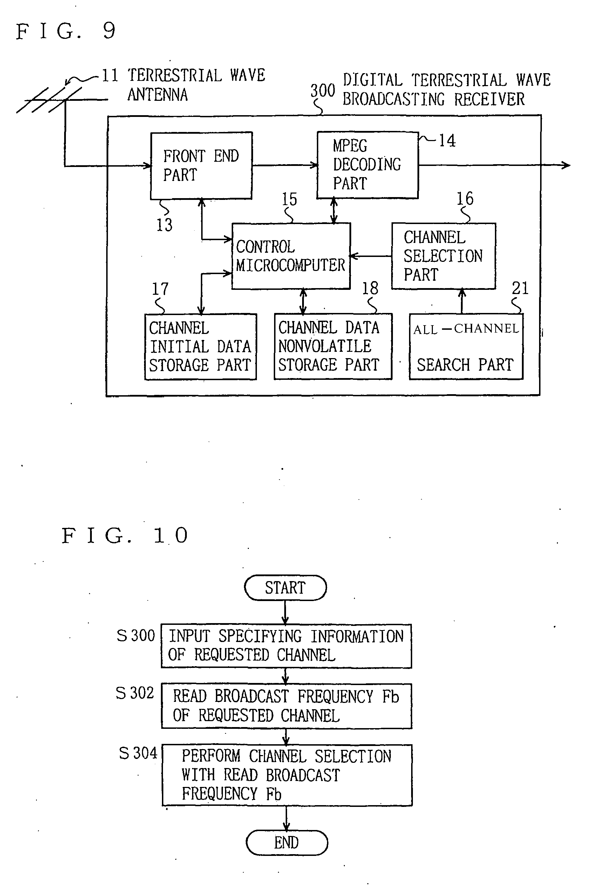

Depicted in FIG. 9 is a block diagram showing the structure of a digital terrestrial broadcasting wave receiver 300 according to a third embodiment of the present invention. The digital terrestrial broadcasting wave receiver 300 is provided with an all-channel search part 21. In this respect, the digital terrestrial broadcasting wave receiver 300 differs from the digital terrestrial broadcasting wave receiver 200 of the second embodiment shown in FIG. 6. Constituents other than the all-channel search part 21 are the same as those in the second embodiment, thus are under the same reference numerals and not described again.

In the third embodiment, the digital terrestrial broadcasting wave receiver typically carries out an operation (referred to as "preset") of searching for the broadcast frequency for every digital-broadcast-receivable channel as of the placement thereof. When the preset is carried out, the all-channel search part 21 sequentially supplies, on a channel basis, information about every possible digital broadcast channel to the channel selection part 16. Whenever receiving the information about channel from the all-channel search part 21, the channel selection part 16 outputs the channel specifying signal Sch specifying the channel. The channel specifying signal Sch is provided to the control microcomputer 15. In this manner, when preset is carried out, one channel specifying signal Sch for every possible digital broadcast channel is provided, on a channel basis, to the control microcomputer 15. Based on the channel specifying signal Sch, the control microcomputer 15 carries out preset in a later-described manner.

### <3.2 Preset Operation and Effects Thereof in Third Embodiment>

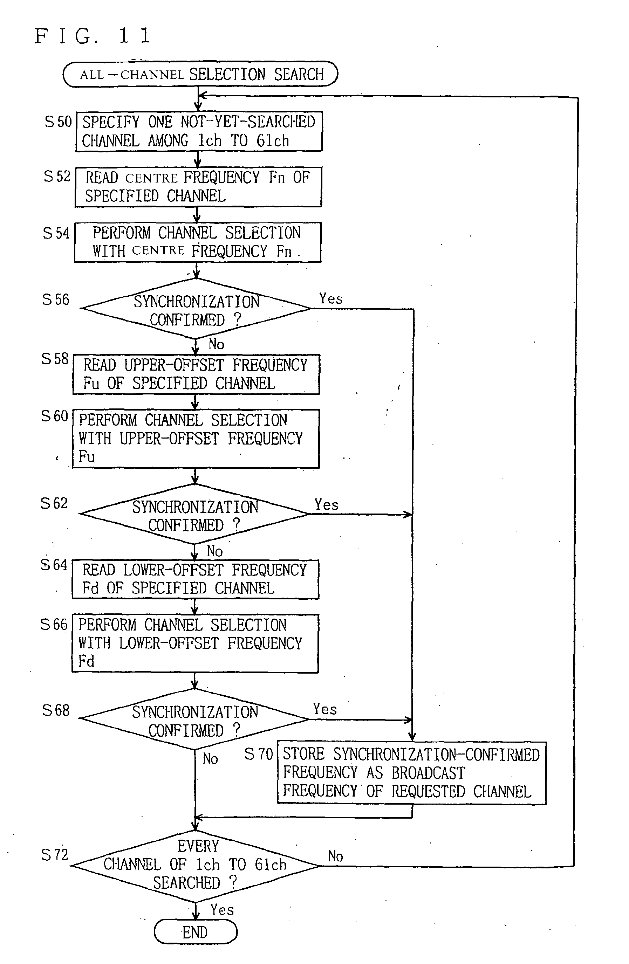

Hereinafter, by referring to FIG. 11, it is described how the digital terrestrial broadcasting wave receiver of the third embodiment carries out preset.

In the third embodiment, preset is carried out through an every channel selection search, the procedure of which is shown in FIG. 11. The every all-channel selection search is started by pushing a specific button (not shown). In the description below, the available digital broadcast channels are presumably 1ch to 61ch.

In the all-channel selection search, the channel selection part 16 first specifies, according to information provided by the all-channel search part, any one channel being not yet through with channel selection among the 1ch to 61ch, that is, any one not-yet-searched channel, and then outputs the channel specifying signal Sch specifying the channel (step S50). Note that, at the point in time immediately after the every channel selection search is started, every channel from 1ch to 61ch is not yet searched. Thus, assuming that the search is sequentially made from a channel smallest in number, the channel specifying signal Sch outputted first is the one specifying the 1ch. Hereinafter, the channel specified by the channel specifying signal Sch outputted in step S50 is referred to as "specified channel".

The channel specifying signal Sch outputted in step S50 is forwarded to the control microcomputer 15, and based thereon, the control microcomputer 15 operates as follows.

First, the control microcomputer 15 reads the normal frequency Fn of the specified channel from the channel initial data storage part 17 (step S52). Thereafter, the control microcomputer 15 generates the control signals Sc1 and Sc2 on the basis of the normal frequency Fn, and then outputs the generated control signals Sc1 and Sc2 to the front end part 13 so as to cause the front end part 13 to carry out channel selection operation with the normal frequency Fn (step S54). Thereafter, the control microcomputer 15 receives the information for synchronization confirmation (OFDM synchronizing signal Ssync, the control voltage signal Svc, or the signal indicating the BER measurement information DBER) from the front end part 13, and based thereon, judges whether or not synchronization has been confirmed (step S56). If synchronization is confirmed through the judgement, the synchronization-confirmed frequency, that is, the normal (or centre) frequency Fn is stored into the channel data nonvolatile storage part 18 as the broadcast frequency of the specified channel (step S70), and then the procedure goes to step S72.

If synchronization is not judged as being confirmed in step S56, the control microcomputer 15 reads the upper-offset frequency Fu of the specified channel from the channel initial data storage part 17 (step S58). Next, the control microcomputer 15 generates the control signals Sc1 and Sc2 on the basis of the upper-offset frequency Fu, and then outputs the generated control signals Sc1 and Sc2 to the front end part 13 so as to cause the front end part 13 to carry out channel selection operation with the upper-offset frequency Fu (step S60). Thereafter, the control microcomputer 15 receives the information for synchronization confirmation from the front end part 13, and based thereon, judges whether or not synchronization has been confirmed (step S62). If synchronization is confirmed through the judgement, the synchronization-confirmed frequency, that is, the upper-offset frequency Fu is stored into the channel data nonvolatile storage part 18 as the broadcast frequency of the specified channel (step S70), and then the procedure goes to step S72.

If synchronization is not judged as being confirmed in step S62, the control microcomputer 15 reads the lower-offset frequency Fd of the specified channel from the channel initial data storage part 17 (step S64). Next, the control microcomputer 15 generates the control signals Sc1 and Sc2 on the basis of the lower-offset frequency Fd, and then outputs the generated control signals Sc1 and Sc2 to the front end part 13 so as to cause the front end part 13 to carry out channel selection operation with the lower-offset frequency Fd (step S66). Thereafter, the control microcomputer 15 receives the information for synchronization confirmation from the front end part 13, and based thereon, judges whether or not synchronization has been confirmed (step S68). If synchronization is confirmed through the judgement, the synchronization-confirmed frequency, that is, the lower-offset frequency Fd is stored into the channel data nonvolatile storage part 18 as the broadcast frequency of the specified channel (step S70), and then the procedure goes to step S72. If synchronization is not confirmed through the judgement, on the other hand, it means that the specified channel is not a digital broadcast channel. If this is the case, the procedure goes to step S72 without the lower-offset frequency being stored into the channel data nonvolatile storage part 18.

In step S72, it is judged whether or not every channel from 1ch to 61ch has been searched. Herein, an expression of " channel is searched" means that the frequency for digital broadcast (broadcast frequency) of the channel is searched through the above-described processing (steps S50 to S70). If the judgement in step S72 tells that some channel is not yet searched, the procedure returns to step S50. From then and onwards, the procedure from S50 to S70 is repeated until every channel is thoroughly searched, and with every channel searched, the all-channel selection search is ended.

According to the above-described preset operation, the all-channel selection search is carried out while taking three possible frequencies to be singularly assigned to one channel into consideration. Therefore, every channel from 1ch to 61ch is assuredly searched for the broadcast frequency thereof. Further, once the preset is carried out, as long as the channel specified by the above all-channel selection search is the digital broadcast channel, the broadcast frequency thereof is stored in the channel data nonvolatile storage part 18.

### <3.3 Channel Selection and Effects Thereof in Third Embodiment>

Next, it is described how channel selection is carried out for the user's requested channel. Herein, it is assumed that preset is carried out by the above-described every channel selection with a user's request.

FIG. 10 is a flowchart showing an exemplary procedure for channel selection (hereinafter, referred to as "first exemplary channel selection") in the third embodiment. In the first exemplary channel selection, after the user operates the channel selection part 16 and specifies a channel for reception (requested channel), the channel specifying signal Sch is provided, as information for specifying the requested channel, from the channel selection part 16 to the control microcomputer 15 (step S300). With the channel specifying signal Sch, the control microcomputer 15 reads the frequency (broadcast frequency) Fb for digital broadcast of the requested channel indicated by the channel specifying signal Sch from the channel data nonvolatile storage part 18 (step S302). Next, the control microcomputer 15 generates the control signals Sc1 and Sc2 on the basis of the read broadcast frequency Fb, and then outputs the generated control signals Sc1 and Sc2 to the front end part 13 so as to cause the front end part 13 to carry out channel selection operation with the broadcast frequency Fb (step S304). If the user's requested channel is a digital broadcast channel, the front end part 13 outputs the transport stream signal of the requested channel by the channel selection operation. The transport stream signal is then decoded by the MPEG decoding part 14, and image data obtained by decoding is externally outputted from the digital terrestrial broadcasting wave receiver.

In the first exemplary channel selection, if some digital broadcast channel is newly provided or changed in frequency (e.g., from the normal (or centre) frequency to the lower-offset frequency) after preset, digital broadcast cannot be correctly received on such channel. If this is the case, channel selection operation similar to that in the second embodiment, i.e., channel selection according to the procedure shown in FIG. 7 (hereinafter, referred to as "second exemplary channel selection"), may be carried out. According to the second exemplary channel selection, when the broadcast frequency of the requested channel is not stored, the broadcast frequency of the requested channel is searched through the single-channel selection search (step S202 in FIG. 7, and FIG. 8). Therefore, even if some digital broadcast channel is newly provided after preset, digital broadcast can be received thereon. Further, according to the second exemplary channel selection, if synchronization is not confirmed through channel selection carried out with the frequency stored as the broadcast frequency of the requested channel, the broadcast frequency of the requested channel is searched through the single-channel selection search (step S210 in FIG. 7, and FIG. 8). In this manner, even if some digital broadcast frequency is changed in frequency after preset, the digital broadcast can be received thereon.

### <4. Fourth Embodiment>

### <4.1 Structure of Fourth Embodiment>

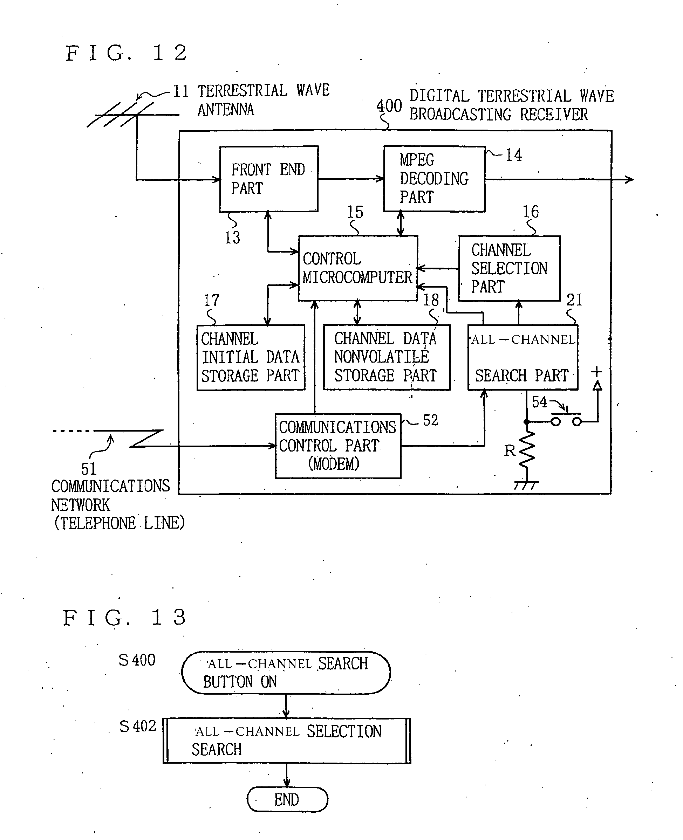

Depicted in FIG. 12 is a block diagram showing the structure of a digital terrestrial broadcasting wave receiver 400 according to a fourth embodiment of the present invention. The digital terrestrial broadcasting wave receiver 400 is provided with a communications control part 52 as means for receiving channel arrangement information. The communications control part 52 is implemented by a modem, for example, and is used to connect the digital terrestrial broadcasting wave receiver to a communications network such as a telephone line or a wide-area network (WAN). In this respect, the digital terrestrial broadcasting wave receiver 400 differs the digital terrestrial broadcasting wave receiver 300 of the third embodiment. Further, the digital terrestrial broadcasting wave receiver 400 is provided with an all-channel search button 54 and a circuit accompanying thereto. The all-channel search button 54 is used to start preset operation in response to the user's instruction. Other constituents are similar to those in the third embodiment, and are under the same reference numerals and not described again.

### <4.2 Operation and Effects of Fourth Embodiment>

In the digital terrestrial broadcasting wave receiver 400 of the fourth embodiment, as shown in FIG. 13, with the all-channel search button 54 pushed (ON) by the user, for example (step S400), a signal indicating the start of the preset operation is provided from the all-channel search part 21 to the control microcomputer 15. Thereafter, according to the procedure shown in FIG. 11, the all-channel selection search is carried out (step S402).

Therefore, according to the fourth embodiment, in the case that some broadcast channel is newly provided or changed in arrangement, the all-channel search button is pushed (ON). As a result, the frequency of the digital broadcast channel newly provided or changed in arrangement is stored in relation to the channel in the channel data nonvolatile storage part 18. In this manner, even if some digital broadcast channel is newly provided or changed in arrangement, digital broadcast can be received thereon. Note that, an expression of "channel is changed in arrangement" means that a broadcast channel is changed from analog to digital or a digital broadcast channel is changed in frequency (e.g., from the normal (or centre) frequency to the upper-offset frequency).

Further, the digital terrestrial broadcasting wave receiver of the fourth embodiment is structured on the premise that, in the case that some digital broadcast channel is newly provided or changed in arrangement, the channel arrangement information is transmitted thereto from the broadcast station via a telephone line or WAN. To be more specific, with the channel arrangement information transmitted from the broadcast station via a communications network 51, the digital terrestrial broadcasting wave receiver 400 receives the information by the communications control part 52. Thereafter, depending on the contents of the received channel arrangement information, the digital terrestrial broadcasting wave receiver 400 goes through any one of the processing next below.
1. In the case that the channel arrangement information notifies only the addition or change in arrangement relevant to some digital broadcast channel,
   on reception of the channel arrangement information (step S410), the communications control part 52 forwards the received channel arrangement information to the all-channel search part 21. In response thereto, the all-channel search part 21 sends an instruction for starting the preset operation to the control microcomputer 15. In this manner, the all-channel selection search is carried out according to the procedure shown in FIG. 11 (step S412).
2. In the case that the channel arrangement information includes any number of the digital broadcast channel newly provided or changed in arrangement,
   on reception of the channel arrangement information including the number N indicating any newly provided channel number or any number of the digital broadcast channel changed in arrangement, the communications control part 52 sends, to the control microcomputer 15, an instruction for channel selection search together with the channel number N. In this manner, the single-channel selection search is carried out according to the procedure shown in FIG. 8 (step S424). Then, with the single-channel selection search, the broadcast frequency for the channel having the number N is determined, and then is stored into the channel data nonvolatile storage part 18.
3. In the case that the channel arrangement information includes information indicating the broadcast frequency of the digital broadcast channel newly provided or changed in arrangement,
   on reception of the channel arrangement information including information indicating the broadcast frequency Fb of the digital broadcast channel newly provided or changed in arrangement, the communications control part 52 sends, to the control microcomputer 15, an instruction for single-channel selection search together with the information indicating the broadcast frequency Fb. In reception thereto, the control microcomputer 15 stores the broadcast frequency Fb into the channel data nonvolatile storage part 18 as the frequency for the digital broadcast channel (step S434).

In the fourth embodiment, with each operation of (1) to (3), a frequency of a digital broadcast channel newly provided or changed in arrangement is newly-stored or updated, respectively, among the broadcast frequencies stored for every channel in the channel data nonvolatile storage part 18. Accordingly, even if some digital broadcast channel is newly provided or changed in arrangement, digital broadcast can be received thereon.

Note that, in the digital terrestrial broadcasting wave receiver of the fourth embodiment, channel selection with a user' s request is similar to the third embodiment. Therefore it is not described again (see FIG. 7, FIG. 8, and FIG. 10).

### <4.3 Exemplary Modification of Fourth Embodiment>

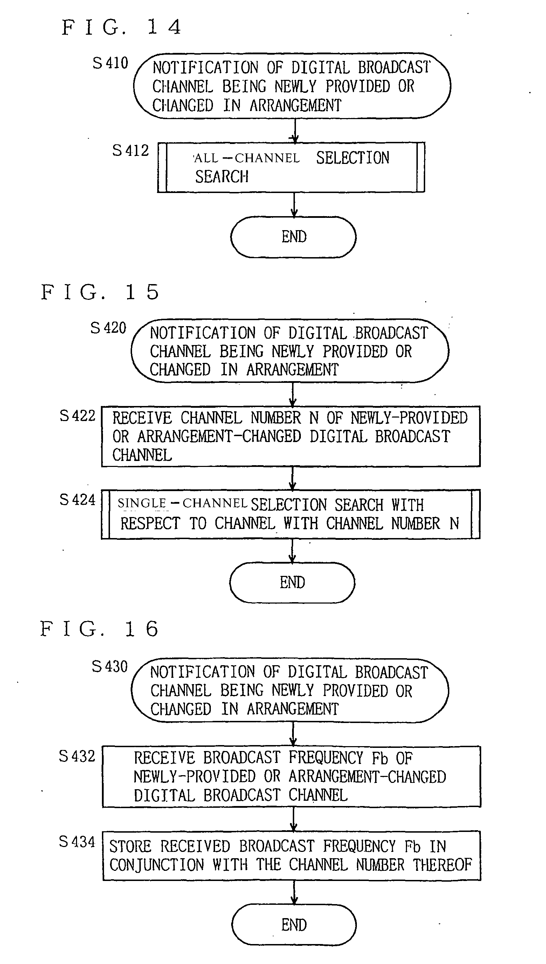

In the fourth embodiment in the foregoing, the channel arrangement information is assumed to be transmitted from broadcast stations only when a digital broadcast channel is newly provided or changed in arrangement. Herein, in the case that the channel arrangement information is regularly transmitted, the operation similar thereto may lead to similar effects (see FIGS. 14 to 16). Further, the channel arrangement information may include information for identifying channels not only newly provided or changed in arrangement but also the digital broadcast channels at the time of transmission thereof, and the broadcast frequency for the channels may be also included. In this case, similarly to the fourth embodiment, the broadcast frequencies of the digital broadcast channel are newly stored or updated in the channel data nonvolatile storage part 18 according to the channel arrangement information.

Further, in the fourth embodiment, the channel arrangement information is transmitted from the broadcast stations to the digital terrestrial broadcasting wave receiver via the communications network such as a telephone line. However, it is not restrictive and the channel arrangement information may be transmitted over airwaves.

### <5. Fifth Embodiment>

### <5.1 Structure of Fifth Embodiment>

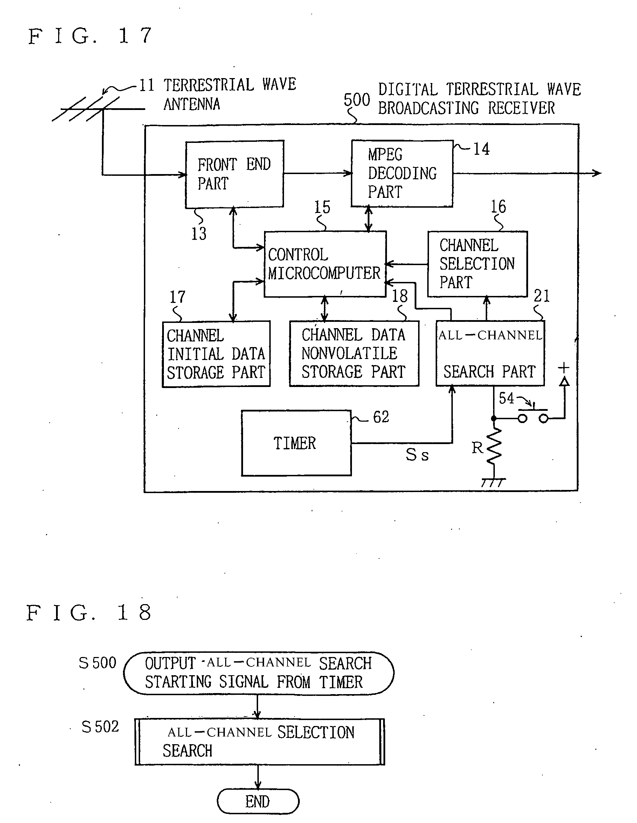

Depicted in FIG. 17 is a block diagram showing the structure of a digital terrestrial broadcasting wave receiver 500 according to a fifth embodiment of the present invention. The digital terrestrial broadcasting wave receiver 500 is provided with a timer 62 outputting a signal for starting the every channel selection search (preset operation) at a predetermined time interval. In this respect, the digital terrestrial broadcasting wave receiver 500 differs from the digital terrestrial broadcasting wave receiver 300 of the third embodiment in FIG. 9. Further, the digital terrestrial broadcasting wave receiver 500 is provided with the all-channel search button 54 and the circuit accompanying thereto. The all-channel search button 54 is used to start the preset operation. Other constituents are the same as those in the third embodiment, thus the same constituents are under the same reference numerals and not described again.

### <5.2 Operation and Effects of Fifth Embodiment>

Also in the digital terrestrial broadcasting wave receiver 500 of the fifth embodiment, similarly to the digital terrestrial broadcasting wave receiver 400 of the fourth embodiment shown in FIG. 12, as shown in FIG. 13, with the all-channel search button 54 pushed (ON) by the user, for example (step S400), a signal indicating start of the preset operation is provided from the all-channel search part 21 to the control microcomputer 15, and then the all-channel selection search is carried out according to the procedure shown in FIG. 11 (step S402).

Therefore, according to the fifth embodiment, similarly to the fourth embodiment, even if some digital broadcast channel is newly provided or changed in arrangement, digital broadcast can be received thereon only by pushing (ON) the all-channel search button.

Further, in the fifth embodiment, to deal with the case that some digital broadcast channel is newly provided or changed in arrangement, the timer 62 is provided. The timer 62 outputs an all-channel search starting signal Ss at a predetermined time interval (e.g.. every day or every week) (step S500). The all-channel search starting signal Ss is forwarded to the all-channel search part 21. In response to the all-channel search starting signal Ss, the all-channel search part 21 sends the instruction for starting the preset operation to the control microcomputer 15. Thereby, the all-channel selection search is carried out according to the procedure shown in FIG. 11 (step S502). As a result, the broadcast frequency of the digital broadcast channel newly provided or changed in arrangement is updated or newly stored among the broadcast frequencies stored for every channel in the channel data nonvolatile storage part 18. In this manner, even if some digital broadcast channel is newly provided or changed in arrangement, digital broadcast can be received thereon.

Note that, also in the digital terrestrial broadcasting wave receiver of the fifth embodiment, channel selection with a user's request is similar to the third embodiment. Therefore, it is not described again (see FIG. 7, FIG. 8, and FIG. 10).

### INDUSTRIAL APPLICABILITY

The present invention is applied to digital terrestrial broadcasting wave receivers, and more specifically suitably applied to a digital terrestrial broadcasting wave receiver used in an area where digital terrestrial broadcasting wave and analog terrestrial broadcasting wave are both observed.

## Claims

1. A digital terrestrial broadcasting wave receiver (100) of a type receiving digital-modulated digital terrestrial wave signals by an antenna (11), and extracting thereamong, for demodulation, one digital terrestrial wave signal corresponding to a digital broadcast channel specified by a user, the receiver (100) comprises:
channel selection means (16) for outputting, when the user specifies a requested channel for reception through a user's operation in a predetermined manner, channel specifying information indicating the requested channel;
**characterized in that :**
the receiver (100) further comprises:
channel initial data storage means (17) for previously storing three possible frequencies of a centre frequency, an upper-offset frequency, and a lower-offset frequency assigned to each of a plurality of predetermined digital broadcast channels;
a front end part (13) for receiving a control signal which instructs a channel selection procedure with any one of said three possible frequencies assigned to said requested channel, carrying out, based on the control signal, extraction and demodulation operations with respect to the digital terrestrial wave signals received by said antenna (11), and generating synchronization confirmation information indicating whether or not the channel selection procedure is successfully completed; and
control means (15) for generating said control signal according to said channel specifying information, and controlling said front end part (13) by supplying said generated control signal to said front end part (13), wherein said control means (15)
includes single-channel selection search means for generating said control signal according to said three possible frequencies assigned to one channel in said channel initial data storage means (17), and searching for a broadcast frequency in actual use for digital broadcast among said three possible frequencies assigned to the one channel, based on said synchronization confirmation information obtained by supplying said generated control signal to said front end part (13), and
determines the broadcast frequency of said requested channel by said single-channel selection search means.

2. The digital terrestrial broadcasting wave receiver as claimed in claim 1, further comprising rewritable nonvolatile storage means for storing a frequency in use for digital broadcast for any one of said predetermined digital broadcast channels in conjunction with each of said channels, wherein said control means
further includes storage judgement means for judging whether or not the broadcast frequency for digital broadcast on said requested channel is stored in said nonvolatile storage means,
when said storage judgement means judges that said broadcast frequency of said requested channel is stored in said nonvolatile storage means, supplies, to said front end part, said control signal instructing the channel selection procedure with said stored broadcast frequency, and
when said storage judgement means does not judge that said broadcast frequency of said requested channel is stored in said nonvolatile storage means, has said single-channel selection search means search for the broadcast frequency of said requested channel, supplies, to said front end part, said control signal instructing the channel selection procedure with the broadcast frequency of said requested channel and stores the broadcast frequency obtained by the search into said nonvolatile storage means in conjunction with said requested channel.

3. The digital terrestrial broadcasting wave receiver as claimed in claim 2, wherein, after generating said control signal instructing the channel selection procedure with the frequency stored in said nonvolatile storage means as the broadcast frequency of said requested channel for output to said front end part, when the channel selection procedure is not successfully completed, said control means supplies said control signal instructing the channel selection procedure with the broadcast frequency of said requested channel by having said single channel selection search means search for the broadcast frequency of said requested channel, and updates said broad-cast frequency stored in said nonvolatile storage means in conjunction with said requested channel to the broadcast frequency obtained by the search.

4. A digital terrestrial broadcasting wave receiver (200) of a type receiving digital-modulated digital terrestrial wave signals by an antenna (11), and extracting thereamong, for demodulation, one digital terrestrial wave signal corresponding to a digital broadcast channel specified by a user, the receiver (200) comprises:
channel selection means (16) for outputting, when the user specifies a requested channel for reception through his/her operation in a predetermined manner,
channel specifying information indicating the requested channel;
**characterized in that:**
the receiver (200) further comprises:
all-channel scan means for receiving a predetermined preset instruction, and in response thereto, sequentially outputting, on a channel basis, channel specifying information which specifies each of a plurality of predetermined digital broadcast channels;
channel initial data storage means (17) for previously storing three possible frequencies of a centre frequency, an upper-offset frequency, and a lower-offset frequency assigned to each of said predetermined digital broadcast channels;
rewritable nonvolatile storage means (18) for storing a frequency in use for digital broadcast on each of said predetermined digital broadcast channels in conjunction with said channels;
a front end part (13) receiving a control signal which instructs a channel selection procedure with any of said three possible frequencies assigned to one channel, carrying out, based on the control signal, extraction and demodulation operations with respect to the digital terrestrial wave signals received by said antenna (11), and generating synchronization confirmation information indicating whether or not the channel selection procedure is successfully completed; and
control means (15) for controlling said front end part (13) by generating said control signal according to said channel specifying information outputted from said channel selection means (16) or said all-channel scan means and by supplying said generated control signal to said front end part (13), wherein said control means (15),
includes all-channel selection search means for generating, when said all-channel scan means receives said preset instruction, said control signal according to said three possible frequencies, stored in said channel initial data storage means (17), being assigned to a specified channel specified by each of the channel specifying information sequentially outputted from said all-channel scan means, searching for a broadcast frequency in actual use for digital broadcast among said three possible frequencies assigned to said specified channel, based on said synchronization confirmation information obtained by supplying said generated control signal to said front end part (13), and storing the broadcast frequency obtained by the search into said nonvolatile storage means (18) in conjunction with said specified channel, and
when said channel specifying information is output from said channel selection means (16), reads the broadcast frequency stored in said nonvolatile storage means (18) in conjunction with said requested channel, and then generates said control signal instructing the channel selection procedure with the read frequency for output to said front end part (13).

5. The digital terrestrial broadcasting wave receiver as claimed in claim 4, wherein said control means further includes single channel selection search means for searching for, based on said synchronization confirmation information obtained by first generating said control signal according to said three possible frequencies assigned to one channel in said channel initial data storage means and then by supplying said generated control signal to said front end part, the broadcast frequency in actual use for digital broadcast among said three possible frequencies assigned to the one channel, and
storage judgement means for judging whether or not the broadcast frequency for digital broadcast on said requested channel is stored in said nonvolatile storage means, and
when said storage judgement means judges that the broadcast frequency of said requested channel is stored in said nonvolatile storage means, supplies said control signal instructing the channel selection procedure with said stored broadcast frequency to said front end part, and
when said storage judgement means does not judge that the broadcast frequency of said requested channel is stored in said nonvolatile storage means, has said single channel selection search means search the broadcast frequency of said requested channel, supplies said control signal instructing the channel selection procedure with the broadcast frequency of said requested channel to said front end part, and stores the broadcast frequency obtained by the search into said nonvolatile storage means in conjunction with said requested channel.

6. The digital terrestrial broadcasting wave receiver as claimed in claim 4, wherein said control means
further includes single-channel selection search means for generating said control signal according to said three possible frequencies assigned to one channel in said channel initial data storage means, and searching for a broadcast frequency in actual use for digital broadcast among said three possible frequencies assigned to the one channel, based on said synchronization confirmation information obtained by and by supplying, said generated control signal to said front end part, and
after generating said control signal instructing the channel selection procedure with the frequency stored in said nonvolatile storage means as the broadcast frequency of said requested channel for output to said front end part, when the channel selection procedure is not successfully completed, has said single-channel selection search means search for the broadcast frequency of said requested channel, supplies said control signal instructing the channel selection procedure with the broadcast frequency of said requested channel to said front end part, and updates said broadcast frequency stored in said nonvolatile storage means in conjunction with said requested channel to the broadcast frequency obtained by the search.

7. The digital terrestrial broadcasting wave receiver as claimed in claim 4, further comprising all-channel search instruction means for providing said preset instruction to said all-channel scan means in response to a user's operation.

8. The digital terrestrial broadcasting wave receiver as claimed in claim 4, further comprising timer means for outputting a signal providing said preset instruction to said all-channel scan means at a predetermined time interval.

9. The digital terrestrial broadcasting wave receiver as claimed in claim 4, further comprising reception means for receiving information transmitted through a predetermined transmission path, and when the received information indicates any digital broadcast channel being newly provided or changed in arrangement, providing said preset instruction to said all-channel scan means

10. The digital terrestrial broadcasting wave receiver as claimed in claim 4, further comprising reception means for receiving information transmitted through a predetermined transmission path, and when the received information includes identifying information of the digital broadcast channel in current use, outputting the identifying information, and said control means further includes single-channel selection search means for generating said control signal according to said three possible frequencies assigned to one channel in said channel initial data storage means, and searching for a broadcast frequency in actual use for digital broadcast among said three possible frequencies assigned to the one channel based on said synchronization confirmation information obtained by and by supplying said generated control signal to said front end part, and
when said identification information is outputted from said reception means, determines the broadcast frequency of the channel identified by said identifying information by said single channel selection search means,
and then stores the determined broadcast frequency into said nonvolatile storage means in conjunction with the channel identified by said identifying information.

11. The digital terrestrial broadcasting wave receiver as claimed in claim 4, further comprising reception means for receiving information transmitted through a predetermined transmission path, and when the received information includes the identifying information and the broadcast frequency of the digital broadcast channel in current use, outputting the identifying information and the broadcast frequency, wherein
when said identifying information and said broadcast frequency are outputted from said reception means, said control means stores said broadcast frequency outputted from said reception means into said nonvolatile storage means in conjunction with the channel identified by said identifying information.

12. The digital terrestrial broadcasting wave receiver as claimed in claim 1 or 4, wherein said digital terrestrial wave signals are OFDM modulated signals, and
said front end part includes OFDM demodulation means for demodulating said digital terrestrial wave signals, and
generates an OFDM synchronizing signal as said synchronization confirmation information when said OFDM demodulation means correctly demodulates said digital terrestrial wave signals

13. The digital terrestrial broadcasting wave receiver as claimed in claim 1 or 4, wherein said digital terrestrial wave signals are OFDM modulated signals, and
said front end part includes OFDM demodulation means for demodulating said digital terrestrial wave signals, and
voltage controlled oscillating means for generating a system clock for said OFDM demodulation means, and
said synchronization confirmation information is a signal indicating a control voltage to be supplied to said voltage controlled oscillating means.

14. The digital terrestrial broadcasting wave receiver as claimed in claim 1 or 4, wherein said digital terrestrial wave signals are OFDM modulated signals, and
said front end part includes OFDM demodulation means for demodulating said digital terrestrial wave signals, and
error correction means for correcting an error included in a signal, if any, obtained by the demodulation carried out by said OFDM demodulation means with respect to said digital terrestrial wave signals, and
said synchronization confirmation information is BER measurement information generated by said error correction means.

15. The digital terrestrial broadcasting wave receiver as claimed in claim 1, wherein said single-channel selection search means searches for the centre frequency with a higher priority among said three possible frequencies.

16. The digital terrestrial broadcasting wave receiver as claimed in claim 4, wherein said all-channel selection search means searches for the centre frequency with a higher priority among said three possible frequencies.

17. The digital terrestrial broadcasting wave receiver as claimed in claim 5 or 6, wherein said all-channel selection search means searches for the centre frequency with a higher priority among said three possible frequencies, and
said single-channel selection search means searches for the centre frequency with a higher priority among said three possible frequencies.

18. The digital terrestrial broadcasting wave receiver as claimed in any one of claims 1, 5 and 6, wherein said single-channel selection search means includes
first synchronization confirmation means for judging, based on the synchronization confirmation information obtained by supplying, to said front end part, the control signal instructing a channel selection procedure with a first frequency included in said three possible frequencies assigned to said
one channel, whether or not the channel selection procedure with the first frequency is successfully completed, and
second synchronization confirmation means for judging whether or not the channel selection procedure with the second frequency is successfully completed, when the channel selection procedure with said first frequency is not judged as being successfully completed, based on the synchronization confirmation information obtained by supplying, to said front end part, the control signal instructing a channel selection procedure with a second frequency included in said three possible frequencies assigned to said one channel but not said first frequency, wherein
when the channel selection procedure with said first frequency is judged as being successfully completed, said first frequency is determined as the broadcast frequency of said one channel, when the channel selection procedure with said second frequency is judged as being successfully completed, said second frequency is determined as the broadcast frequency of said one channel, and when neither of the channel selection procedures with said first nor second frequencies is judged as being successfully completed, a third frequency included in said three possible frequencies assigned to said one channel but not said first or said second frequency is determined as the broadcast frequency of said one channel.

19. The digital terrestrial broadcasting wave receiver as claimed in any one of claims 1, 5 and 6, wherein said single-channel selection search means includes:
first synchronization confirmation means for judging whether or not the channel selection procedure with the first frequency is successfully completed, based on the synchronization confirmation information obtained by supplying, to said front end part, the control signal instructing a channel selection procedure with a first frequency which is any one of said three possible frequencies assigned to said one channel;
second synchronization confirmation means for judging whether or not the channel selection procedure with the second frequency is successfully completed, when the channel selection procedure with said first frequency is not judged as being successfully completed, based on the synchronization confirmation information obtained by supplying, to said front end part, the control signal instructing a channel selection procedure with a second frequency included in said three possible frequencies assigned to said one channel but not said first frequency; and
third synchronization confirmation means for judging whether or not the channel selection procedure with the third frequency is completed successfully, when neither of the channel selection procedures with said first nor second frequencies is not judged as being successfully completed, based on the synchronization confirmation information obtained by supplying, to said front end part, the control signal instructing a channel selection procedure with a third frequency included in said three possible frequencies assigned to said one channel but not said first or second frequency, wherein
when the channel selection procedure with said first frequency is judged as being successfully completed, said first frequency is determined as the broadcast frequency of said one channel, when the channel selection procedure with said second frequency is judged as being successfully completed, said second frequency is determined as the broadcast frequency of said one channel, and when the channel selection procedure with said third frequency is judged as being successfully completed, said third frequency is determined as the broadcast frequency of said one channel.

20. The digital terrestrial broadcasting wave receiver as claimed in any one of claims 4, 5 or 6, wherein said all-channel selection search means includes: first synchronization confirmation means for judging whether or not the channel selection procedure with the first frequency is successfully completed, based on the synchronization confirmation information obtained by supplying, to said front end part, the control signal instructing a channel selection procedure with a first frequency which is any one of said three possible frequencies assigned to said specified channel;
second synchronization confirmation means for judging whether or not the channel selection procedure with the second frequency is successfully completed, when the channel selection procedure with said first frequency is not judged as being successfully completed, based on the synchronization confirmation information obtained by supplying, to said front end part, the control signal instructing a channel selection procedure with a second frequency included in said three possible frequencies assigned to said specified channel but not said first frequency; and
third synchronization confirmation means for judging whether or not the channel selection procedure with the third frequency is successfully completed, when neither of the channel selection procedures with said first nor second frequencies is not judged as being successfully completed, based on the synchronization confirmation information obtained by supplying, to said front end part, the control signal instructing a channel selection procedure with a third frequency included in said three possible frequencies assigned to said specified channel but not said first or second frequency,
wherein
when the channel selection procedure with said first frequency is judged as being successfully completed, said first frequency is stored into said nonvolatile storage means as the broadcast frequency of said specified channel, when the channel selection procedure with said second frequency is judged as being successfully completed, said second frequency is stored into said nonvolatile storage means as the broadcast frequency of said specified channel, and when the channel selection procedure with said third frequency is judged as being successfully completed, is stored into said nonvolatile storage means as the broadcast frequency of said specified channel.

21. A reception channel selection method to be applied to a digital terrestrial broadcasting wave receiver (100) of a type receiving digital-modulated digital terrestrial wave signals by an antenna (11), and extracting thereamong, for demodulation, one digital terrestrial wave signal corresponding to a digital broadcast channel specified by a user,
**characterized in that** the method comprises:
a channel initial data storing step of previously storing three possible frequencies including a centre frequency, an upper-offset frequency, and a lower-offset frequency assigned to every predetermined digital broadcast channel;
a channel specifying step of outputting, when the user specifies a requested channel for reception through a user's operation in a predetermined manner, channel specifying information indicating the requested channel;
a control signal generating step of generating, based on said three possible frequencies assigned to said requested channel in said channel initial data storing step, a control signal which instructs a channel selection procedure with any one of said three possible frequencies assigned to said requested channel;
a synchronization confirmation information generating step of carrying out, based on said generated control signal, extraction and demodulation operations with respect to the digital terrestrial wave signals received by said antenna, and generating synchronization confirmation information indicating whether or not said channel selection procedure including the selection and demodulation operations is successfully completed; and a search step of searching for, based on said synchronization confirmation information, a broadcast frequency in actual use for digital broadcast among said three possible frequencies assigned to said requested channel.

22. A reception channel selection method to be applied to a digital terrestrial broadcasting wave receiver (200) of a type receiving digital-modulated digital terrestrial wave signals by an antenna, and extracting thereamong, for demodulation, one digital terrestrial wave signal corresponding to a digital broadcast channel specified by a user,
**characterized in that** the method comprises:
a channel initial data storing step of previously storing three possible frequencies including a centre frequency, an upper-offset frequency, and a lower-offset frequency assigned to every predetermined digital broadcast channel;
an all-channel scan step of receiving a predetermined preset instruction, and in response thereto, sequentially outputting, on a channel basis, channel specifying information which specifies each of a plurality of predetermined digital broadcast channels;
a first control signal generating step of generating, on reception of said preset instruction, based on said previously stored three possible frequencies assigned to a specified channel specified by each of said channel specifying information sequentially outputted, a control signal instructing a channel selection procedure with any one of said three possible frequencies;
a synchronization confirmation information generating step of carrying out, based on said control signal generated in said first control signal generating step, extraction and demodulation operations with respect to the digital terrestrial wave signals received by said antenna, and generating synchronization confirmation information indicating whether or not said channel selection procedure including the extraction and demodulation operations are successfully completed;
a search step of searching for, based on said synchronization confirmation information, a broadcast frequency in actual use for digital broadcast among said three possible frequencies assigned to said specified channel;
a storage step of storing the broadcast frequency obtained in said search step into predetermined nonvolatile storage means in conjunction with said specified channel;
a channel specifying step of outputting channel specifying information indicating a requested channel in response to the user's requested channel for reception through the user's operation in a predetermined manner;
a reading step of reading the broadcast frequency stored in said nonvolatile storage means in conjunction with said requested channel when said channel specifying information is outputted in said channel specifying step;
a second control signal generating step of generating a control signal instructing a channel selection with said frequency read from said nonvolatile storage means; and
a channel selection procedure step of carrying out extraction and demodulation operations with respect to the digital terrestrial wave signals received by said antenna based on said control signal generated in said second control signal generating step.

## Patentansprüche

1. Digitaler Empfänger (100) für terrestrische Funkwellen, von einem Typ, welcher digital modulierte digitale terrestrische Wellensignale durch eine Antenne (11) empfängt, und daraus zur Demodulation ein digitales terrestrisches Wellensignal extrahiert, welches einem durch einen Benutzer spezifizierten digitalen Funkkanal entspricht, wobei der Empfänger (100) aufweist:
Kanalauswahlmittel (16) zum Ausgeben, wenn der Benutzer einen angeforderten Kanal zum Empfangen spezifiziert durch eine Operation des Benutzers auf eine vorherbestimmte Weise, von Kanalspezifizierungsinformation, welche den angeforderten Kanal anzeigt;
**dadurch gekennzeichnet, dass**
der Empfänger (100) ferner aufweist:
Kanalanfangsdatenspeichermittel (17) zum vorhergehenden Speichern dreier möglicher Frequenzen einer Mittenfrequenz, einer oberen Offset-Frequenz und einer unteren Offset-Frequenz, zugewiesen zu jedem einer Mehrzahl vorherbestimmter digitaler Funkkanäle;
einem Frontendteil (13) zum Empfangen eines Kontrollsignals, welches eine Kanalauswahlprozedur anweist, mit irgendeiner der drei möglichen Frequenzen, die dem angeforderten Kanal zugewiesen sind, wobei basierend auf dem Kontrollsignal Extraktions- und Demodulationsoperationen mit Bezug auf das digitale terrestrische Wellensignale ausgeführt werden, welche durch die Antenne 11 empfangen sind, und Synchronisationsbestätigungsinformation erzeugt wird, welche anzeigt, ob die Kanalauswahlprozedur erfolgreich vollendet wurde oder nicht; und
Kontrollmittel (15) zum Erzeugen des Kontrollsignals gemäß der Kanalspezifizierungsinformation und Kontrollieren des Frontendteils (13) durch bereitstellen des erzeugten Kontrollsignals an den Frontendteil (13), worin die Kontrollmittel 15 Einzelkanalauswahlsuchmittel enthalten zum Erzeugen des Kontrollsignals gemäß den drei möglichen Frequenzen in den Kanalanfangsdatenspeichermitteln (17), die einem Kanal zugewiesen sind, und Suchen nach einer Funkfrequenz in tatsächlicher Verwendung zur digitalen Funkübertragung unter den drei möglichen Frequenzen, die dem einen Kanal zugewiesen sind, basierend auf der Synchronisationsbestätigungsinformation, erhalten durch liefern des erzeugten Kontrollsignals an den Frontendteil (13); und
die Funkübertragungsfrequenz des angeforderten Kanals bestimmt durch die Einzelkanalauswahlsuchmittel.

2. Digitaler terrestrischer Funkwellenempfänger nach Anspruch 1, ferner aufweisend wiederbeschreibbare nichtvolatile Speichermittel zum Speichern einer Frequenz in Verwendung zur digitalen Funkübertragung für irgendeinen der vorherbestimmten digitalen Funkübertragungskanäle in Zusammenhang mit jedem der Kanäle, worin die Kontrollmittel
ferner Speicherbeurteilungsmittel enthalten zum Beurteilen, ob die Funkübertragungsfrequenz zur digitalen Funkübertragung auf dem angeforderten Kanal in den nichtvolatilen Speichermitteln gespeichert ist oder nicht,
wenn das Speicherbeurteilungsmittel beurteilt, dass die Funkübertragungsfrequenz des angeforderten Kanals in den nichtvolatilen Speichermitteln gespeichert ist, das Kontrollsignal an den Frontendteil bereitstellt, welches die Kanalauswahlprozedur mit der gespeicherten Funkübertragungsfrequenz anweist, und
wenn das Speicherbeurteilungsmittel nicht beurteilt, dass die Funkübertragungsfrequenz des angeforderten Kanals in den nichtvolatilen Speichermitteln gespeichert ist, die Einzelkanalauswahlsuchmittel dazu veranlasst, nach der Funkübertragungsfrequenz des angeforderten Kanals zu suchen, an den Frontendteil das Kontrollsignal bereitstellt, welches die Kanalauswahlprozedur anweist, mit der Funkübertragungsfrequenz des angeforderten Kanals und die durch die Suche erhaltene Funkübertragungsfrequenz in die nichtvolatilen Speichermittel im Zusammenhang mit dem angeforderten Kanal einspeichert.

3. Digitaler terrestrischer Funkwellenempfänger nach Anspruch 2, worin, nach erzeugen des Kontrollsignals, welches die Kanalauswahlprozedur anweist, mit der Frequenz, die in den nichtvolatilen Speichermitteln gespeichert ist, als die Funkübertragungsfrequenz des angeforderten Kanals zur Ausgabe an den Frontendteil, wenn die Kanalauswahlprozedur nicht erfolgreich vollendet wurde, das Kontrollmittel das Kontrollsignal, welches die Kanalauswahlprozedur anweist, mit der Funkübertragungsfrequenz des angeforderten Kanals, indem das Einzelkanalauswahlsuchmittel veranlasst wird, nach der Funkübertragungsfrequenz des angeforderten Kanals zu suchen, und die in den nichtvolatilen Speichermitteln im Zusammenhang mit dem angeforderten Kanal gespeicherte Funkübertragungsfrequenz auf die durch die Suche erhaltene Funkübertragungsfrequenz aktualisiert.

4. Digitaler terrestrischer Funkübertragungswellenempfänger (200) von einem Typ, welcher digital modulierte digitale terrestrische Wellensignale über eine Antenne (11) empfängt und darunter zur Demodulation ein digitales terrestrisches Wellensignal entsprechend einem durch einen Benutzer spezifizierten digitalen Funkübertragungskanal extrahiert, wobei der Empfänger (200) aufweist:
Kanalauswahlmittel (16) zum Ausgeben, wenn der Benutzer einen angeforderten Kanal zum Empfang durch seine/ihre Operation in einer vorherbestimmten Weise spezifiziert, von Kanalspezifizierungsinformation, welche den angeforderten Kanal anzeigt;
**dadurch gekennzeichnet, dass**
der Empfänger (200) ferner aufweist:
Allkanalscanmittel zum Empfangen einer vorherbestimmten Voreinstellungsanweisung, und in Antwort darauf, sequenziellen Ausgeben auf einer Kanalbasis von Kanalspezifizierungsinformation, die jeden aus einer Vielzahl von vorherbestimmten digitalen Funkübertragungskanälen spezifiziert;
Kanalanfangsdatenspeichermittel (17) zum vorherigen Speichern von drei möglichen Frequenzen einer Mittenfrequenz, einer oberen Offset-Frequenz und einer unteren Offset-Frequenz, die zu jedem der vorherbestimmten digitalen Funkübertragungskanäle zugewiesen sind;
wiederbeschreibbare nichtvolatile Speichermittel (18) zum Speichern einer Frequenz in Verwendung zur digitalen Funkübertragung auf jedem der vorherbestimmten digitalen Funkübertragungskanäle in Zusammenhang mit den Kanälen;
einem Frontendteil (13), welcher ein Kontrollsignal empfängt, das eine Kanalauswahlprozedur mit irgendeinem der drei möglichen Frequenzen, die einem Kanal zugewiesen sind, ausführt welcher basierend auf dem Kontrollsignal Extraktions- und Demodulationsoperationen mit Bezug auf die digitalen terrestrischen Wellensignale, die durch die Antenne (11) empfangen sind, ausführt, und Synchronisationsbestätigungsinformation erzeugt, welche anzeigt, ob die Kanalauswahlprozedur erfolgreich vollendet wurde oder nicht; und
Kontrollmittel (15) zum Kontrollieren des Frontendteils (13) durch erzeugen des Kontrollsignals gemäß der Kanalspezifizierungsinformation, die von den Kanalauswahlmitteln (16) oder dem Allkanalscanmitteln ausgegeben ist, und durch bereitstellen des erzeugten Kontrollsignals an den Frontendteil (13), worin
das Kontrollmittel (15)
Allkanalauswahlsuchmittel enthält zum Erzeugen, wenn das Allkanalscanmittel die Voreinstellungsanweisung empfängt, des Kontrollsignals gemäß den drei möglichen Frequenzen, gespeichert in den Kanalanfangsdatenspeichermitteln (17), welche einem spezifischen Kanal, der durch jede der Kanalsspezifizierungsinformation spezifiziert ist, die sequenziell von den Allkanalscanmitteln ausgegeben ist, zugewiesen ist, Suchen nach eine Funkübertragungsfrequenz in tatsächlicher Verwendung zur digitalen Funkübertragung unter den drei möglichen Frequenzen, die dem spezifizierten Kanal zugewiesen sind, basierend auf der Synchronisationsbestätigungsinformation, die erhalten wurde durch bereitstellen des erzeugten Kontrollsignals an den Frontendteil (13), und Speichern der Funkübertragungsfrequenz, welche durch die Suche erhalten wurde, in die nichtvolatilen Speichermittel (18) in Zusammenhang mit dem spezifizierten Kanal, und
wenn die Kanalspezifizierungsinformation ausgegeben wird von den Kanalauswahlmitteln (16), die Funkübertragungsfrequenz, die in dem nichtvolatilen Speichermitteln (18) in Zusammenhang mit dem angeforderten Kanal gespeichert ist, ausliest und dann das Kontrollsignal erzeugt, welches die Kanalauswahlprozedur mit der ausgelesenen Frequenz anweist, zur Ausgabe an ein Frontendteil (13).

5. Digitaler terrestrischer Funkübertragungswellenempfänger nach Anspruch 4, worin das Kontrollmittel ferner Einzelkanalauswahlsuchmittel enthält zum Suchen nach, basierend auf der Synchronisationsbestätigungsinformation, die erhalten wurde durch zu erst erzeugen des Kontrollsignals gemäß den drei möglichen Frequenzen, die einem Kanal zugewiesen sind, in den Kanalanfangsdatenspeichermitteln und dann bereitstellen des erzeugten Kontrollsignals an ein Frontendteil, der Funkübertragungsfrequenz in tatsächlicher Verwendung für digitale Funkübertragung unter den drei möglichen Frequenzen, die dem einen Kanal zugewiesen sind, und
Speicherbeurteilungsmittel zum Beurteilen, ob die Funkübertragungsfrequenz zur digitalen Funkübertragung auf dem angeforderten Kanal in den nichtvolatilen Speichermitteln gespeichert ist oder nicht, und
wenn das Speicherbeurteilungsmittel beurteilt, dass die Funkübertragungsfrequenz des angeforderten Kanals in den nichtvolatilen Speichermitteln gespeichert ist, das Kontrollsignal bereitstellt, welches die Kanalsauswahlprozedur mit der gespeicherten Funkübertragungsfrequenz anweist, an den Frontendteil, und
wenn das Speicherbeurteilungsmittel nicht beurteilt, dass die Funkübertragungsfrequenz des angeforderten Kanals in den nichtvolatilen Speichermitteln gespeichert ist, ein Einzelkanalauswahlsuchmittel veranlasst, die Funkübertragungsfrequenz des angeforderten Kanals zu suchen, das Kontrollsignal welches die Kanalauswahlprozedur mit der Funkübertragungsfrequenz des angeforderten Kanals anweist, an den Frontendteil bereitstellt, und die Funkübertragungsfrequenz, die durch die Suche erhalten wurde, in die nichtvolatilen Speichermittel in Zusammenhang mit dem angeforderten Kanal einspeichert.

6. Digitaler terrestrischer Funkübertragungswellenempfänger nach Anspruch 4, worin das Kontrollmittel
ferner Einzelkanalauswahlsuchmittel enthält zum Erzeugen des Kontrollsignals gemäß den drei möglichen Frequenzen, die einem Kanal zugewiesen sind, in den Kanalanfangsdatenspeichermitteln, und suchen nach einer Funkübertragungsfrequenz in tatsächlicher Verwendung zur digitalen Funkübertragung unter den drei möglichen Frequenzen, die dem einen Kanal zugewiesen sind, basierend auf der Synchronisationsbestätigungsinformation, erhalten durch und durch bereitstellen des erzeugten Kontrollsignals an ein Frontendteil, und
nach erzeugen des Kontrollsignals, Anweisen der Kanalauswahlprozedur mit der Frequenz, die in den nichtvolatilen Speichermitteln gespeichert ist, als die Funkübertragungsfrequenz des angeforderten Kanals zur Ausgabe an ein Frontendteil, wenn die Kanalauswahlprozedur nicht erfolgreich vollendet wurde, das Einzelkanalauswahlsuchmittel veranlasst wird, die Funkübertragungsfrequenz des angeforderten Kanals zu suchen, das Kontrollsignal, welches die Kanalauswahlprozedur anweist mit der Funkübertragungsfrequenz des angeforderten Kanals, an den Frontendteil bereitstellt und die Funkübertragungsfrequenz, die in den nichtvolatilen Speichermitteln in Zusammenhang mit dem angeforderten Kanal gespeichert ist, auf die durch die Suche erhaltene Funkübertragungsfrequenz aktualisiert.

7. Digitaler terrestrischer Funkübertragungswellenempfänger nach Anspruch 4, ferner aufweisend Allkanalsuchanweisungsmittel zum Bereitstellen der Voreinstellungsanweisung an die Allkanalscanmittel in Antwort auf eine Operation eines Benutzers.

8. Digitaler terrestrischer Funkübertragungswellenempfänger nach Anspruch 4, ferner aufweisend Timermittel zum Ausgeben eines Signals, welches die Voreinstellungsanweisung an die Allkanalscanmittel zu einem vorherbestimmten Zeitintervall bereitstellt.

9. Digitaler terrestrischer Funkübertragungswellenempfänger nach Anspruch 4, ferner aufweisend Empfangsmittel zum Empfangen von Information, übertragen durch einen vorherbestimmten Übertragungspfad, und wenn die empfangene Information irgendeinen digitalen Funkübertragungskanal anzeigt, der neu bereitgestellt oder in Anordnung geändert ist, bereitstellen der Voreinstellungsanweisung an die Allkanalscanmittel.

10. Digitaler terrestrischer Funkübertragungswellenempfänger nach Anspruch 4, ferner aufweisend Empfangsmittel zum Empfangen von Information, die über einen vorherbestimmten Übertragungspfad übertragen wird, und wenn die empfangene Information Identifizierungsinformation des digitalen Funkübertragungskanals in gegenwärtiger Verwendung enthält, ausgegeben der Identifizierungsinformation und
das Kontrollmittel enthält ferner Einzelkanalauswahlsuchmittel zum Erzeugen des Kontrollsignals gemäß den drei möglichen Frequenzen, die einem Kanal in den Kanalanfangsdatenspeichermitteln zugewiesen sind, und suchen nach einer Funkübertragungsfrequenz in tatsächlicher Verwendung zur digitalen Funkübertragung unter den drei möglichen Frequenzen, die dem einen Kanal zugewiesen sind, basierend auf der Synchronisationsbestätigungsinformation, erhalten durch und durch bereitstellen des erzeugten Steuersignals an ein Frontendteil, und
wenn die Identifikationsinformation von den Empfangsmitteln ausgegeben wird, die Funkübertragungsfrequenz bestimmt des Kanals, der durch die Identifikationsinformation identifiziert ist, durch die Einzelkanalauswahlsuchmittel, und dann die bestimmte Funkübertragungsfrequenz in die nichtvolatilen Speichermittel in Zusammenhang mit dem durch die Identifikationsinformation identifizierten Kanal einspeichert.

11. Digitaler terrestrischer Funkübertragungswellenempfänger nach Anspruch 4, ferner aufweisend ein Empfangsmittel zum Empfangen von Information, die über einen vorherbestimmten Übertragungspfad übertragen wurde, und wenn die empfangene Information die Identifikationsinformation und die Funkübertragungsfrequenz des digitalen Funkübertragungskanals in gegenwärtiger Verwendung enthält, Ausgeben der Identifikationsinformation und der Funkübertragungsfrequenz, worin
wenn die Identifikationsinformation und Funkübertragungsfrequenz von dem Empfangsmittel ausgegeben wird, speichert das Kontrollmittel die Funkübertragungsfrequenz, die von dem Empfangsmittel ausgegeben wurde, in die nichtvolatilen Speichermittel in Zusammenhang mit dem Kanal, der durch die Identifikationsinformation identifiziert wurde.

12. Digitaler terrestrischer Funkübertragungswellenempfänger nach Anspruch 1 oder 4, worin die digitalen terrestrischen Wellensignale OFDM modulierte Signale sind und
der Frontendteil enthält OFDM Demodulationsmittel zum Demodulieren der digitalen terrestrischen Wellensignale, und
erzeugt ein OFDM Synchronisationssignal als die Synchronisationsbestätigungsinformation, wenn das OFDM Demodulationsmittel korrekt die digitalen terrestrischen Wellensignale demoduliert.

13. Digitaler terrestrischer Funkübertragungswellenempfänger nach Anspruch 1 oder 4, worin die digitalen terrestrischen Wellensignale OFDM modulierte Signale sind, und
der Frontendteil enthält OFDM Demodulationsmittel zum Demodulieren der digitalen terrestrischen Wellensignale, und
spannungsgesteuerte Oszillationsmittel zum Erzeugen eines Systemtakts für die OFDM Demodulationsmittel, und
die Synchronisationsbestätigungsinformation ist ein Signal, welches eine Steuerspannung anzeigt, das den spannungsgesteuerten Oszillationsmitteln bereitzustellen ist.

14. Digitaler terrestrischer Funkübertragungswellenempfänger nach Anspruch 1 oder 4, worin die digitalen terrestrischen Wellensignale OFDM modulierte Signale sind, und
der Frontendteil enthält OFDM Demodulationsmittel zum Demodulieren der digitalen terrestrischen Wellensignale, und
Fehlerkorrekturmittel zum Korrigieren eines Fehlers, der in einem Signal enthalten ist, falls es einen gibt, erhalten durch die Demodulation, die durch die OFDM Demodulationsmittel ausgeführt wurde mit Bezug auf die digitalen terrestrischen Wellensignale, und
die Synchronisationsbestätigungsinformation ist eine BER Messungsinformation, erzeugt durch die Fehlerkorrekturmittel.

15. Digitaler terrestrischer Funkübertragungswellenempfänger nach Anspruch 1, worin das Einzelkanalauswahlsuchmittel nach der Mittenfrequenz mit einer höheren Priorität unter den drei möglichen Frequenzen sucht.

16. Digitaler terrestrischer Funkübertragungswellenempfänger nach Anspruch 4, worin das Allkanalauswahlsuchmittel nach der Mittenfrequenz mit einer höheren Priorität unter den drei möglichen Frequenzen sucht.

17. Digitaler terrestrischer Funkübertragungswellenempfänger nach Anspruch 5 oder 6, worin das Allkanalauswahlsuchmittel nach der Mittenfrequenz mit einer höheren Priorität unter den drei möglichen Frequenzen sucht, und
das Einzelkanalauswahlsuchmittel nach der Mittenfrequenz mit einer höheren Priorität unter den drei möglichen Frequenzen sucht.

18. Digitaler terrestrischer Funkübertragungswellenempfänger nach einem der Ansprüche 1, 5 und 6, worin das Einzelkanalauswahlsuchmittel enthält
erste Synchronisationsbestätigungsmittel zum Beurteilen, basierend auf der Synchronisationsbestätigungsinformation, die erhalten wurde durch bereitstellen, an den Frontendteil, des Kontrollsignals, das eine Kanalauswahlprozedur mit einer ersten Frequenz anweist, die in den drei möglichen Frequenzen enthalten ist, die dem einen Kanal zugewiesen sind, ob die Kanalauswahlprozedur mit der ersten Frequenz erfolgreich vollendet wurde oder nicht, und
zweite Synchronisationsbestätigungsmittel zum Beurteilen, ob die Kanalauswahlprozedur mit der zweiten Frequenz erfolgreich vollendet wurde oder nicht, wenn die Kanalauswahlprozedur mit der ersten Frequenz nicht als erfolgreich vollendet beurteilt wird, basierend auf der Synchronisationsbestätigungsinformation, die erhalten wurde durch bereitstellen, an den Frontendteil, des Kontrollsignals, das eine Kanalauswahlprozedur mit einer zweiten Frequenz anweist, die in den drei möglichen Frequenzen, die dem einen Kanal zugewiesen sind, enthalten ist, aber nicht die erste Frequenz, worin
wenn die Kanalauswahlprozedur mit der ersten Frequenz als erfolgreich beendet beurteilt wird, die erste Frequenz als die Funkübertragungsfrequenz des einen Kanals bestimmt wird, wenn die Kanalauswahlprozedur mit der zweiten Frequenz als erfolgreich vollendet bestimmt wird, die zweite Frequenz als die Funkübertragungsfrequenz des einen Kanals bestimmt wird, und wenn keine der Kanalauswahlprozeduren mit der ersten oder der zweiten Frequenz als erfolgreich beendet bestimmte wurde, eine dritte Frequenz, die in den drei möglichen Frequenzen enthalten ist, die dem einen Kanal zugewiesen sind, aber nicht die erste oder die zweite Frequenz ist, als die Funkübertragungsfrequenz des einen Kanals bestimmt wird.

19. Digitaler terrestrischer Funkübertragungswellenempfänger nach einem der Ansprüche 1, 5 und 6, worin das Einzelkanalauswahlsuchmittel enthält:
erste Synchronisationsbestätigungsmittel zum Beurteilen, ob die Kanalauswahlprozedur mit der ersten Frequenz erfolgreich beendet wurde oder nicht, basierend auf der Synchronisationsbestätigungsinformation, die erhalten wurde durch bereitstellen, an den Frontendteil, des Kontrollsignals, welches eine Kanalauswahlprozedur mit einer ersten Frequenz anweist, die irgendeine der drei möglichen Frequenzen ist, die dem einen Kanal zugewiesen sind;
zweite Synchronisationsbestätigungsmittel zum Beurteilen, ob die Kanalauswahlprozedur mit der zweiten Frequenz erfolgreich beendet wurde oder nicht, wenn die Kanalauswahlprozedur mit der ersten Frequenz nicht als erfolgreich beendet beurteilt wurde, basierend auf der Synchronisationsbestätigungsinformation, die erhalten wurde durch bereitstellen, an den Frontendteil, des Kontrollsignals, das eine Kanalauswahlprozedur mit einer zweiten Frequenz anweist, die in den drei möglichen Frequenzen enthalten ist, die dem einen Kanal zugewiesen sind, aber nicht die erste Frequenz ist; und
dritte Synchronisationsbestätigungsmittel zum Beurteilen, ob die Kanalauswahlprozedur mit der dritten Frequenz erfolgreich beendet wurde oder nicht, wenn keine der Kanalauswahlprozeduren mit den ersten oder zweiten Frequenzen als erfolgreich beendet beurteilt werden, basierend auf der Synchronisationsbestätigungsinformation, die erhalten wird durch bereitstellen, an den Frontendteil, des Kontrollsignals, das eine Kanalauswahlprozedur mit einer dritten Frequenz anweist, die in den drei möglichen Frequenzen enthalten ist, die dem einen Kanal zugewiesen sind, aber nicht die erste und nicht die zweite Frequenz, worin
wenn die Kanalauswahlprozedur mit der ersten Frequenz als erfolgreich beendet beurteilt wird, wird die erste Frequenz als die Funkübertragungsfrequenz des einen Kanal bestimmt, wenn die Kanalauswahlprozedur mit der zweiten Frequenz als erfolgreich beendet beurteilt wird, die zweite Frequenz wird als die Funkübertragungsfrequenz des einen Kanals bestimmt, und wenn die Kanalauswahlprozedur mit der dritten Frequenz als erfolgreich beendet beurteilt wird, wird die dritte Frequenz als die Funkübertragungsfrequenz des einen Kanals bestimmt.

20. Digitaler terrestrischer Funkübertragungswellenempfänger nach einem der Ansprüche 4, 5 oder 6, worin das Allkanalauswahlsuchmittel enthält:
erste Synchronisationsbestätigungsmittel zum Beurteilen, ob die Kanalauswahlprozedur mit der ersten Frequenz erfolgreich beendet wurde oder nicht, basierend auf der Synchronisationsbestätigungsinformation, die erhalten wird durch bereitstellen, an den Frontendteil, des Kontrollsignals, das eine Kanalauswahlprozedur mit einer ersten Frequenz anweist, die irgendeine der drei möglichen Frequenzen ist, die dem spezifizierten Kanal zugewiesen sind;
zweite Synchronisationsbestätigungsmittel zum Beurteilen, ob die Kanalauswahlprozedur mit der zweiten Frequenz erfolgreich beendet wurde oder nicht, wenn die Kanalauswahlprozedur mit der ersten Frequenz nicht als erfolgreich beendet beurteilt wird, basierend auf der Synchronisationsbestätigungsinformation, die erhalten wurde durch bereitstellen, an den Frontendteil, des Kontrollsignals, das eine Kanalauswahlprozedur mit einer zweiten Frequenz anweist, die in den drei möglichen Frequenzen enthalten ist, die dem spezifizierten Kanal zugewiesen sind, aber nicht die erste Frequenz; und
dritte Synchronisationsbestätigungsmittel zum Beurteilen, ob die Kanalauswahlprozedur mit der dritten Frequenz erfolgreich beendet wurde, wenn weder die Kanalauswahlprozeduren mit der ersten noch der zweiten Frequenz als erfolgreich beendet beurteilt werden, basierend auf der Synchronisationsbestätigungsinformation, die erhalten wurde durch bereitstellen, an den Frontendteil, des Kontrollsignals, das eine Kanalauswahlprozedur mit einer dritten Frequenz anweist, die in den drei möglichen Frequenzen enthalten ist, die dem spezifizierten Kanal zugewiesen sind, aber weder die erste noch die zweite Frequenz ist, worin
wenn die Kanalauswahlprozedur mit der ersten Frequenz als erfolgreich beendet beurteilt wird, wird die erste Frequenz in den nichtvolatilen Speichermitteln als die Funkübertragungsfrequenz des spezifizierten Kanals eingespeichert, wenn die Kanalauswahlprozedur mit der zweiten Frequenz als erfolgreich beendet beurteilt wird, wird die zweite Frequenz in die nichtvolatilen Speichermittel als die Funkübertragungsfrequenz des spezifizierten Kanals eingespeichert, und wenn die Kanalauswahlprozedur mit der dritten Frequenz als erfolgreich beendet bestimmt wird, wird in die nichtvolatilen Speichermittel als die Funkübertragungsfrequenz des spezifizierten Kanals eingespeichert.

21. Empfangskanalauswahlverfahren, anzuwenden auf einen digitalen terrestrischen Funkübertragungswellenempfänger 100 von einem Typ, der digital modulierte digitale terrestrische Wellensignale durch eine Antenne 12 empfängt, und darunter zur Demodulation ein digitales terrestrisches Wellensignal extrahiert, das einem durch einen Benutzer spezifizierten digitalen Funkübertragungskanal entspricht,
**dadurch gekennzeichnet, dass**
das Verfahren aufweist:
einen Kanalanfangsdatenspeicherschritt zum vorherigen Speichern von drei möglichen Frequenzen einschließlich einer Mittenfrequenz, einer oberen Offset-Frequenz und einer unteren Offset-Frequenz, zugewiesen zu jedem vorherbestimmten digitalen Funkübertragungskanal;
einen Kanalspezifizierungsschritt zum Ausgeben, wenn der Benutzer einen angeforderten Kanal zum Empfang durch eine Benutzeroperation auf eine vorherbestimmte Weise spezifiziert, Kanalspezifizierungsinformation, welche den angeforderten Kanal anzeigt;
einen Kontrollsignalerzeugungsschritt zum Erzeugen, basierend auf den drei möglichen Frequenzen, die dem angeforderten Kanal zugewiesen sind in dem Kanalanfangsdatenspeicherschritt, eines Kontrollsignals, das eine Kanalauswahlprozedur mit irgendeiner der drei möglichen Frequenzen, die dem angeforderten Kanal zugewiesen sind, anweist;
eine Synchronisationsbestätigungsinformationserzeugungsschritt zum Ausführen, basierend auf dem erzeugten Kontrollsignal, von Extraktions- und Demodulationsoperationen mit Bezug auf die durch die Antenne empfangenen digitalen terrestrischen Wellensignale und Erzeugen von Synchronisationsbestätigungsinformation, welche anzeigt, ob die Kanalauswahlprozedur einschließlich der Auswahl- und Demodulationsoperationen erfolgreich beendet wurde oder nicht; und
einen Suchschritt zum Suchen, basierend auf der Synchronisationsbestätigungsinformation, nach einer Funkübertragungsfrequenz in tatsächlicher Verwendung zur digitalen Funkübertragung unter den drei möglichen Frequenzen, die dem angeforderten Kanal zugewiesen sind.

22. Empfangskanalauswahlverfahren, anzuwenden auf einen digitalen terrestrischen Funkübertragungswellenempfänger (200) von einem Typ, der digital modulierte digitale terrestrische Wellensignal über eine Antenne empfängt und darunter zur Demodulation ein digitales terrestrisches Wellensignal extrahiert, welches einem durch einen Benutzer spezifizierten digitalen Funkübertragungskanal entspricht,
**dadurch gekennzeichnet, dass** das Verfahren aufweist:
einen Kanalanfangsdatenspeicherschritt zum vorhergehenden Speichern von drei möglichen Frequenzen einschließlich einer Mittenfrequenz, einer oberen Offset-Frequenz und einer unteren Offset-Frequenz, zugewiesen zu jedem vorherbestimmten digitalen Funkübertragungskanal;
einen Allkanalscannschritt zum Empfangen einer vorherbestimmten Voreinstellungsanweisung und in Antwort darauf sequenziellen Ausgeben, auf einer Kanalbasis, von Kanalspezifierungsinformation, die jeden von einer Vielzahl von vorherbestimmten digitalen Funkübertragungskanälen spezifiziert;
einen ersten Kontrollsignalerzeugungsschritt zum Erzeugen auf Empfang der Voreinstellungsanweisung, basierend auf den vorhergehend gespeicherten drei möglichen Frequenzen, die einem spezifischen Kanal zugewiesen sind, spezifiziert durch jeden der sequenziell ausgegebenen Kanalspezifizierungsinformation, ein Kontrollsignal, welches eine Kanalauswahlprozedur anweist mit irgendeiner der drei möglichen Frequenzen;
einen Synchronisationsbestätigungsinformationserzeugungsschritt zum Ausführen, basierend auf dem in dem ersten Kontrollsignalerzeugungsschritt erzeugten Kontrollsignal, von Extraktions- und Demodulationsoperation mit Bezug auf die durch die Antenne empfangenen digitalen terrestrischen Wellensignale und Erzeugen von Synchronisationsbestätigungsinformation, welche anzeigt, ob die Kanalauswahlprozedur, einschließlich den Extraktions- und Demodulationsoperationen, erfolgreich beendet wurde oder nicht;
einen Suchschritt zum Suchen, basierend auf der Synchronisationsbestätigungsinformation, nach einer Funkübertragungsfrequenz in tatsächlicher Verwendung für digitale Funkübertragung unter den drei möglichen Frequenzen, die dem spezifizierten Kanal zugewiesen sind;
einen Speicherschritt zum Speichern der Funkübertragungsfrequenz, die in dem Suchschritt erhalten wurde, in vorherbestimmte nichtvolatile Speichermittel in Zusammenhang mit dem spezifizierten Kanal;
einen Kanalspezifizierungsschritt zum Ausgeben von Kanalspezifizierungsinformation, welche einem angeforderten Kanal anzeigt in Antwort auf den durch den Benutzer angeforderten Kanal zum Empfang durch die Benutzeroperation auf eine vorherbestimmte Weise;
einen Ausleseschritt zum Auslesen der in den nichtvolatilen Speichermitteln im Zusammenhang mit dem angeforderten Kanal gespeicherten Funkübertragungsfrequenz, wenn die Kanalspezifizierungsinformation in dem Kanalspezifizierungsschritt ausgegeben wird;
einen zweiten Kontrollsignalerzeugungsschritt zum Erzeugen eines Kontrollsignals, das eine Kanalauswahl mit der von den nichtvolatilen Speichermitteln ausgelesenen Frequenz anweist; und
einen Kanalauswahlprozedurschritt zum Ausführen von Extraktions- und Demodulationsoperationen mit Bezug auf die durch die Antenne empfangenen digitalen terrestrischen Wellensignale basierend auf dem in dem zweiten Kontrollsignalerzeugungsschritt erzeugten Kontrollsignal.

## Revendications

1. Récepteur d'ondes pour la diffusion numérique terrestre (100) d'un type qui reçoit les signaux d'onde numériques terrestres modulés de manière numérique par une antenne (11), et qui extrait parmi ceux-là, pour une démodulation, un signal d'onde numérique terrestre correspondant à un canal de diffusion en numérique spécifié par un utilisateur, le récepteur (100) comprend :
un moyen de sélection d'un canal (16) pour délivrer, lorsque l'utilisateur spécifie un canal demandé pour la réception à travers une opération de l'utilisateur selon une manière prédéterminée, des informations de spécification d'un canal qui indiquent le canal demandé ;
**caractérisé en ce que** :
le récepteur (100) comprend en outre :
un moyen de stockage de données initiales pour un canal (17) pour stocker auparavant trois fréquences possibles parmi une fréquence centrale, une fréquence avec un décalage supérieur et une fréquence avec un décalage inférieur attribuées à chacun d'une pluralité de canaux de diffusion en numérique prédéterminés ;
une partie d'extrémité avant (13) pour recevoir un signal de commande qui ordonne une procédure de sélection d'un canal avec l'une quelconque desdites trois fréquences possibles attribuées au dit canal demandé, pour effectuer, sur la base du signal de commande, les opérations d'extraction et de démodulation en ce qui concerne les signaux d'onde numériques terrestres reçus par ladite antenne (11) et pour générer des informations de confirmation de synchronisation indiquant si la procédure de sélection d'un canal est, ou non, terminée avec succès ; et
un moyen de commande (15) pour générer ledit signal de commande selon lesdites informations de spécification d'un canal et pour commander ladite partie d'extrémité avant (13) en fournissant ledit signal de commande généré à ladite partie d'extrémité avant (13), dans lequel
ledit moyen de commande (15)
inclut un moyen de recherche de sélection d'un seul canal pour générer ledit signal de commande selon lesdites trois fréquences possibles attribuées à un canal dans ledit moyen de stockage de données initiales pour un canal (17) et pour rechercher une fréquence de diffusion utilisée réellement pour une diffusion en numérique parmi lesdites trois fréquences possibles attribuées au seul canal, sur la base desdites informations de confirmation de synchronisation obtenues en fournissant ledit signal de commande généré à ladite partie d'extrémité avant (13), et détermine la fréquence de diffusion dudit canal demandé par ledit moyen de recherche de sélection d'un seul canal.

2. Récepteur d'ondes pour la diffusion numérique terrestre comme revendiqué dans la revendication 1, comprenant, en outre, un moyen de stockage non volatile réinscriptible pour stocker une fréquence utilisée pour la diffusion en numérique pour l'un quelconque desdits canaux de diffusion en numérique prédéterminés conjointement avec chacun desdits canaux, dans lequel
ledit moyen de commande
inclut, en outre, un moyen de jugement du stockage pour juger si la fréquence de diffusion pour une diffusion en numérique sur ledit canal demandé est, ou non, stockée dans ledit moyen de stockage non volatile,
lorsque ledit moyen de jugement du stockage juge que ladite fréquence de diffusion dudit canal demandé est stockée dans ledit moyen de stockage non volatile, fournit, à ladite partie d'extrémité avant, ledit signal de commande ordonnant la procédure de sélection d'un canal avec ladite fréquence de diffusion stockée, et
lorsque ledit moyen de jugement du stockage ne juge pas que ladite fréquence de diffusion dudit canal demandé est stockée dans ledit moyen de stockage non volatile, a ledit moyen de recherche de sélection d'un seul canal pour rechercher la fréquence de diffusion dudit canal demandé, fournit, à ladite partie d'extrémité avant, ledit signal de commande ordonnant la procédure de sélection d'un canal avec ladite fréquence de diffusion dudit canal demandé et stocké la fréquence de diffusion obtenue par la recherche dans ledit moyen de stockage non volatile conjointement avec ledit canal demandé.

3. Récepteur d'ondes pour la diffusion numérique terrestre comme revendiqué dans la revendication 2, dans lequel, après la génération dudit signal de commande ordonnant la procédure de sélection d'un canal avec la fréquence stockée dans ledit moyen de stockage non volatile comme étant la fréquence de diffusion dudit canal demandé pour une sortie à ladite partie d'extrémité avant, lorsque la procédure de sélection d'un canal n'est pas terminée avec succès, ledit moyen de commande fournit ledit signal de commande ordonnant la procédure de sélection d'un canal avec la fréquence de diffusion dudit canal demandé en ayant ledit moyen de recherche de sélection d'un seul canal pour rechercher la fréquence de diffusion dudit canal demandé et met à jour ladite fréquence de diffusion stockée dans ledit moyen de stockage non volatile conjointement avec ledit canal demandé à la fréquence de diffusion obtenue par la recherche.

4. Récepteur d'ondes pour la diffusion numérique terrestre (200) d'un type qui reçoit les signaux d'onde numériques terrestres modulés de manière numérique par une antenne (11), et qui extrait parmi ceux-là, pour une démodulation, un signal d'onde numérique terrestre correspondant à un canal de diffusion en numérique spécifié par un utilisateur, le récepteur (200) comprend :
un moyen de sélection d'un canal (16) pour délivrer, lorsque l'utilisateur spécifie un canal demandé pour la réception à travers son opération selon une manière prédéterminée, des informations de spécification d'un canal qui indiquent le canal demandé ;
**caractérisé en ce que** :
le récepteur (200) comprend en outre :
un moyen de balayage de tous les canaux pour recevoir une instruction préétablie prédéterminée et, en réponse à celle-là, pour délivrer séquentiellement, sur un canal de base, les informations de spécification d'un canal qui spécifient chacun d'une pluralité de canaux de diffusion en numérique prédéterminés ;
un moyen de stockage de données initiales pour un canal (17) pour stocker auparavant trois fréquences possibles parmi une fréquence centrale, une fréquence avec un décalage supérieur et une fréquence avec un décalage inférieur, attribuées à chacun des canaux de diffusion en numérique prédéterminés ;
un moyen de stockage non volatile réinscriptible (18) pour stocker une fréquence utilisée pour une diffusion en numérique sur chacun desdits canaux de diffusion en numérique prédéterminés conjointement avec lesdits canaux ;
une partie d'extrémité avant (13) recevant un signal de commande qui ordonne une procédure de sélection d'un canal avec l'une quelconque desdites trois fréquences possibles attribuées à un canal, effectuant, sur la base du signal de commande, les opérations d'extraction et de démodulation en ce qui concerne les signaux d'onde numériques terrestres reçus par ladite antenne (11) et générant des informations de confirmation de synchronisation indiquant si la procédure de sélection d'un canal est, ou non, terminée avec succès ; et
un moyen de commande (15) pour commander ladite partie d'extrémité avant (13) en générant ledit signal de commande selon lesdites informations de spécification d'un canal délivrées dudit moyen de sélection d'un canal (16) ou dudit moyen de balayage de tous les canaux et en fournissant ledit signal de commande généré à ladite partie d'extrémité avant (13), dans lequel
ledit moyen de commande (15)
inclut un moyen de recherche de sélection de tous les canaux pour générer, lorsque ledit moyen de balayage de tous les canaux reçoit ladite instruction préétablie, ledit signal de commande selon lesdites trois fréquences possibles, stockées dans ledit moyen de stockage de données initiales pour un canal (17), qui sont attribuées à un canal spécifié attribué par chacune des informations de spécification d'un canal délivrées séquentiellement depuis ledit moyen de balayage de tous les canaux, pour rechercher une fréquence de diffusion utilisée réellement pour une diffusion en numérique parmi lesdites trois fréquences possibles attribuées au dit canal spécifié, sur la base desdites informations de confirmation de synchronisation obtenues en fournissant ledit signal de commande généré à ladite partie d'extrémité avant (13), et pour stocker la fréquence de diffusion obtenue par la recherche dans ledit moyen de stockage non volatile (18) conjointement avec ledit canal spécifié, et
lorsque lesdites informations de spécification d'un canal sont délivrées depuis ledit moyen de sélection d'un canal (16), lit la fréquence de diffusion stockée dans ledit moyen de stockage non volatile (18) conjointement avec ledit canal demandé, et génère ensuite ledit signal de commande ordonnant la procédure de sélection d'un canal avec la fréquence lue pour une sortie à ladite partie d'extrémité avant (13).

5. Récepteur d'ondes pour la diffusion numérique terrestre comme revendiqué dans la revendication 4, dans lequel ledit moyen de commande inclut, en outre, un moyen de recherche de sélection d'un seul canal pour rechercher, sur la base desdites informations de confirmation de synchronisation obtenues en générant d'abord ledit signal de commande selon lesdites trois fréquences possibles attribuées à un canal dans ledit moyen de stockage de données initiales pour un canal et en fournissant ensuite ledit signal de commande généré à ladite partie d'extrémité avant, la fréquence de diffusion utilisée réellement pour une diffusion en numérique parmi lesdites trois fréquences possibles attribuées au seul canal, et
un moyen de jugement du stockage pour juger si la fréquence de diffusion pour une diffusion en numérique sur ledit canal demandé est, ou non, stockée dans ledit moyen de stockage non volatile, et
lorsque ledit moyen de jugement du stockage juge que la fréquence de diffusion dudit canal demandé est stockée dans ledit moyen de stockage non volatile, fournit ledit signal de commande ordonnant la procédure de sélection d'un canal avec ladite fréquence de diffusion stockée à ladite partie d'extrémité avant, et
lorsque ledit moyen de jugement du stockage ne juge pas que la fréquence de diffusion dudit canal demandé est stockée dans ledit moyen de stockage non volatile, a ledit moyen de recherche de sélection d'un seul canal pour rechercher la fréquence de diffusion dudit canal demandé, fournit ledit signal de commande ordonnant la procédure de sélection d'un canal avec la fréquence de diffusion dudit canal demandé à ladite partie d'extrémité avant, et stocké la fréquence de diffusion obtenue par la recherche dans ledit moyen de stockage non volatile conjointement avec ledit canal demandé.

6. Récepteur d'ondes pour la diffusion numérique terrestre comme revendiqué dans la revendication 4, dans lequel ledit moyen de commande
inclut, en outre, un moyen de recherche de sélection d'un seul canal pour générer ledit signal de commande selon lesdites trois fréquences possibles attribuées à un canal dans ledit moyen de stockage de données initiales pour un canal, et pour rechercher une fréquence de diffusion utilisée réellement pour la diffusion en numérique parmi les trois fréquences possibles attribues à un canal, sur la base desdites informations de confirmation de synchronisation obtenues par, et en fournissant, ledit signal de commande généré à ladite partie d'extrémité avant, et
après la génération dudit signal de commande, ordonnant la procédure de sélection d'un canal avec la fréquence stockée dans ledit moyen de stockage non volatile comme étant la fréquence de diffusion dudit canal demandé pour une sortie à ladite partie d'extrémité avant, lorsque la procédure de sélection d'un canal n'est pas terminée avec succès, a ledit moyen de recherche de sélection d'un seul canal pour rechercher la fréquence de diffusion dudit canal demandé, fournit ledit signal de commande ordonnant la procédure de sélection d'un canal avec la fréquence de diffusion dudit canal demandé à ladite partie d'extrémité avant et met à jour ladite fréquence de diffusion stockée dans ledit moyen de stockage non volatile conjointement avec ledit canal demandé à la fréquence de diffusion obtenue par la recherche.

7. Récepteur d'ondes pour la diffusion numérique terrestre comme revendiqué dans la revendication 4, comprenant, en outre, un moyen d'instruction de recherche de tous les canaux pour fournir ladite instruction préétablie au dit moyen de balayage de tous les canaux en réponse à une opération de l'utilisateur.

8. Récepteur d'ondes pour la diffusion numérique terrestre comme revendiqué dans la revendication 4, comprenant, en outre, un moyen de temporisation pour délivrer un signal fournissant ladite instruction préétablie au dit moyen de balayage de tous les canaux à un intervalle de temps prédéterminé.

9. Récepteur d'ondes pour la diffusion numérique terrestre comme revendiqué dans la revendication 4, comprenant, en outre, un moyen de réception pour recevoir les informations transmises à travers un chemin de transmission prédéterminé et, lorsque les informations reçues indiquent qu'un quelconque canal de diffusion est nouvellement prévu ou est changé dans l'arrangement, pour fournir ladite instruction préétablie au dit moyen de balayage de tous les canaux.

10. Récepteur d'ondes pour la diffusion numérique terrestre comme revendiqué dans la revendication 4, comprenant, en outre, un moyen de réception pour recevoir les informations transmises à travers un chemin de transmission prédéterminé et, lorsque les informations reçues incluent des informations d'identification du canal de diffusion en numérique en usage courant, pour délivrer les informations d'identification, et
ledit moyen de commande inclut, en outre, un moyen de recherche de sélection d'un seul canal pour générer ledit signal de commande selon lesdites trois fréquences possibles attribuées à un canal dans ledit moyen de stockage de données initiales pour un canal et pour rechercher une fréquence de diffusion utilisée réellement pour une diffusion en numérique parmi lesdites trois fréquences possibles attribuées au seul canal, sur la base desdites informations de confirmation de synchronisation obtenues par et en fournissant ledit signal de commande généré à ladite partie d'extrémité avant, et
lorsque lesdites informations d'identification sont délivrées depuis ledit moyen de réception, détermine la fréquence de diffusion du canal identifié par lesdites informations d'identification par ledit moyen de recherche de sélection d'un seul canal, et stocke ensuite la fréquence de diffusion déterminée dans ledit moyen de stockage non volatile conjointement avec le canal identifié par lesdites informations d'identification.

11. Récepteur d'ondes pour la diffusion numérique terrestre comme revendiqué dans la revendication 4, comprenant, en outre, un moyen de réception pour recevoir les informations transmises à travers un chemin de transmission prédéterminé et, lorsque les informations reçues incluent des informations d'identification et la fréquence de diffusion du canal de diffusion en numérique en usage courant, pour délivrer les informations d'identification et la fréquence de diffusion, dans lequel
lorsque lesdites informations d'identification et ladite fréquence de diffusion sont délivrées depuis ledit moyen de réception, ledit moyen de commande stocke ladite fréquence de diffusion délivrée depuis ledit moyen de réception dans ledit moyen de stockage non volatile conjointement avec le canal identifié par lesdites informations d'identification.

12. Récepteur d'ondes pour la diffusion numérique terrestre comme revendiqué dans la revendication 1 ou 4, dans lequel lesdits signaux d'onde numériques terrestres sont des signaux modulés par un multiplexage OFDM (multiplexage orthogonal par division de fréquence), et
ladite partie d'extrémité avant inclut un moyen de démodulation OFDM pour démoduler lesdits signaux d'onde numériques terrestres, et
génère un signal de synchronisation OFDM comme étant lesdites informations de confirmation de synchronisation lorsque ledit moyen de démodulation OFDM démodule correctement lesdits signaux d'onde numériques terrestres.

13. Récepteur d'ondes pour la diffusion numérique terrestre comme revendiqué dans la revendication 1 ou 4, dans lequel lesdits signaux d'onde numériques terrestres sont des signaux modulés par un multiplexage OFDM, et
ladite partie d'extrémité avant inclut un moyen de démodulation OFDM pour démoduler lesdits signaux d'onde numériques terrestres, et
un moyen d'oscillation commandé en tension pour générer une horloge système pour ledit moyen de démodulation OFDM, et
lesdites informations de confirmation de synchronisation sont un signal indiquant une tension de commande qui doit être fournie au dit moyen d'oscillation commandé en tension.

14. Récepteur d'ondes pour la diffusion numérique terrestre comme revendiqué dans la revendication 1 ou 4, dans lequel lesdits signaux d'onde numériques terrestres sont des signaux modulés par un multiplexage OFDM, et
ladite partie d'extrémité avant inclut un moyen de démodulation OFDM pour démoduler lesdits signaux d'onde numériques terrestres, et
un moyen de correction d'erreur pour corriger, s'il y en a, une erreur incluse dans un signal obtenu par la démodulation effectuée par ledit moyen de démodulation OFDM en ce qui concerne lesdits signaux d'onde numériques terrestres, et
lesdites informations de confirmation de synchronisation sont des informations de mesure du BER (taux d'erreur sur les bits) générées par ledit moyen de correction d'erreur.

15. Récepteur d'ondes pour la diffusion numérique terrestre comme revendiqué dans la revendication 1, dans lequel ledit moyen de recherche de sélection d'un seul canal recherche la fréquence centrale avec une priorité plus élevée parmi lesdites trois fréquences possibles.

16. Récepteur d'ondes pour la diffusion numérique terrestre comme revendiqué dans la revendication 4, dans lequel ledit moyen de recherche de sélection de tous les canaux recherche la fréquence centrale avec une priorité plus élevée parmi lesdites trois fréquences possibles.

17. Récepteur d'ondes pour la diffusion numérique terrestre comme revendiqué dans la revendication 5 ou 6, dans lequel ledit moyen de recherche de sélection de tous les canaux recherche la fréquence centrale avec une priorité plus élevée parmi lesdites trois fréquences possibles, et
ledit moyen de recherche de sélection d'un seul canal recherche la fréquence centrale avec une priorité plus élevée parmi lesdites trois fréquences possibles.

18. Récepteur d'ondes pour la diffusion numérique terrestre comme revendiqué dans l'une quelconque des revendications 1, 5 et 6, dans lequel ledit moyen de recherche de sélection d'un seul canal inclut
un premier moyen de confirmation de synchronisation pour juger, sur la base des informations de confirmation de synchronisation obtenues en fournissant, à ladite partie d'extrémité avant, le signal de commande ordonnant une procédure de sélection d'un canal avec une première fréquence incluse dans lesdites trois fréquences possibles attribuées au dit un seul canal, si la procédure de sélection d'un canal avec la première fréquence est, ou non, terminée avec succès, et
un second moyen de confirmation de synchronisation pour juger si la procédure de sélection d'un canal avec la seconde fréquence est, ou non, terminée avec succès, lorsque la procédure de sélection d'un canal avec ladite première fréquence n'est pas jugée comme étant terminée avec succès, sur la base des informations de confirmation de synchronisation obtenues en fournissant, à ladite partie d'extrémité avant, le signal de commande ordonnant une procédure de sélection d'un canal avec une seconde fréquence incluse dans lesdites trois fréquences possibles attribuées au dit un seul canal mais pas avec ladite première fréquence, dans lequel
lorsque la procédure de sélection d'un canal avec ladite première fréquence est jugée comme étant terminée avec succès, ladite première fréquence est déterminée être la fréquence de diffusion dudit un seul canal, lorsque la procédure de sélection d'un canal avec ladite seconde fréquence est jugée comme étant terminée avec succès, ladite seconde fréquence est déterminée être la fréquence de diffusion dudit un seul canal et lorsque aucune des procédures de sélection d'un canal avec lesdites première ou seconde fréquences n'est jugée être terminée avec succès, une troisième fréquence incluse dans lesdites trois fréquences possibles attribuées au dit un seul canal mais non pas ladite première fréquence ou ladite seconde fréquence est déterminée être la fréquence de diffusion dudit un seul canal.

19. Récepteur d'ondes pour la diffusion numérique terrestre comme revendiqué dans l'une quelconque des revendications 1, 5 et 6, dans lequel ledit moyen de recherche de sélection d'un seul canal inclut :
un premier moyen de confirmation de synchronisation pour juger si la procédure de sélection d'un canal avec la première fréquence est, ou non, terminée avec succès, sur la base des informations de confirmation de synchronisation obtenues en fournissant, à ladite partie d'extrémité avant, le signal de commande ordonnant une procédure de sélection d'un canal avec une première fréquence qui est l'une quelconque desdites trois fréquences possibles attribuées au dit un seul canal ;
un second moyen de confirmation de synchronisation pour juger si la procédure de sélection d'un canal avec la seconde fréquence est, ou non, terminée avec succès, lorsque la procédure de sélection d'un canal avec ladite première fréquence n'est pas jugée comme étant terminée avec succès, sur la base des informations de confirmation de synchronisation obtenues en fournissant, à ladite partie d'extrémité avant, le signal de commande ordonnant une procédure de sélection d'un canal avec une seconde fréquence incluse dans lesdites trois fréquences possibles attribuées au dit un seul canal mais pas avec ladite première fréquence ; et
un troisième moyen de confirmation de synchronisation pour juger si la procédure de sélection d'un canal avec la troisième fréquence est, ou non, terminée avec succès, lorsque aucune des procédures de sélection d'un canal avec lesdites première ou seconde fréquences n'est jugée être terminée avec succès, sur la base des informations de confirmation de synchronisation obtenues en fournissant, à ladite partie d'extrémité avant, le signal de commande ordonnant une procédure de sélection d'un canal avec une troisième fréquence incluse dans lesdites trois fréquences possibles attribuées au dit un seul canal mais pas avec ladite première fréquence ou avec la seconde fréquence, dans lequel
lorsque la procédure de sélection d'un canal avec ladite première fréquence est jugée comme étant terminée avec succès, ladite première fréquence est déterminée être la fréquence de diffusion dudit un seul canal, lorsque la procédure de sélection d'un canal avec ladite seconde fréquence est jugée comme étant terminée avec succès, ladite seconde fréquence est déterminée être la fréquence de diffusion dudit un seul canal et lorsque la procédure de sélection d'un canal avec ladite troisième fréquence est jugée comme étant terminée avec succès, ladite troisième fréquence est déterminée être la fréquence de diffusion dudit un seul canal.

20. Récepteur d'ondes pour la diffusion numérique terrestre comme revendiqué dans l'une quelconque des revendications 4, 5 ou 6, dans lequel ledit moyen de recherche de sélection de tous les canaux inclut :
un premier moyen de confirmation de synchronisation pour juger si la procédure de sélection d'un canal avec la première fréquence est, ou non, terminée avec succès, sur la base des informations de confirmation de synchronisation obtenues en fournissant, à ladite partie d'extrémité avant, le signal de commande ordonnant une procédure de sélection d'un canal avec une première fréquence qui est l'une quelconque desdites trois fréquences possibles attribuées au dit canal spécifié ;
un second moyen de confirmation de synchronisation pour juger si la procédure de sélection d'un canal avec la seconde fréquence est, ou non, terminée avec succès, lorsque la procédure de sélection d'un canal avec ladite première fréquence n'est pas jugée comme étant terminée avec succès, sur la base des informations de confirmation de synchronisation obtenues en fournissant, à ladite partie d'extrémité avant, le signal de commande ordonnant une procédure de sélection d'un canal avec une seconde fréquence incluse dans lesdites trois fréquences possibles attribuées au dit canal spécifié mais pas avec ladite première fréquence ; et
un troisième moyen de confirmation de synchronisation pour juger si la procédure de sélection d'un canal avec la troisième fréquence est, ou non, terminée avec succès, lorsque aucune des procédures de sélection d'un canal avec lesdites première ou seconde fréquences n'est jugée être terminée avec succès, sur la base des informations de confirmation de synchronisation obtenues en fournissant, à ladite partie d'extrémité avant, le signal de commande ordonnant une procédure de sélection d'un canal avec une troisième fréquence incluse dans lesdites trois fréquences possibles attribuées au dit canal spécifié mais pas avec ladite première fréquence ou avec la seconde fréquence, dans lequel
lorsque la procédure de sélection d'un canal avec ladite première fréquence est jugée comme étant terminée avec succès, ladite première fréquence est stockée dans ledit moyen de stockage non volatile comme étant la fréquence de diffusion dudit canal spécifié, lorsque la procédure de sélection d'un canal avec ladite seconde fréquence est jugée comme étant terminée avec succès, ladite seconde fréquence est stockée dans ledit moyen de stockage non volatile comme étant la fréquence de diffusion dudit canal spécifié, et lorsque la procédure de sélection d'un canal avec ladite troisième fréquence est jugée comme étant terminée avec succès, ladite troisième fréquence est stockée dans ledit moyen de stockage non volatile comme étant la fréquence de diffusion dudit canal spécifié.

21. Procédé de sélection d'un canal de réception qui doit être appliqué à un récepteur d'ondes pour la diffusion numérique terrestre (100) d'un type qui reçoit des signaux d'onde numériques terrestres modulés de manière numérique par une antenne (11) et qui extrait parmi ceux-là, pour une démodulation, un signal d'onde numérique terrestre correspondant à un canal de diffusion en numérique spécifié par un utilisateur,
**caractérisé en ce que** le procédé comprend :
une étape de stockage des données initiales pour un canal consistant à stocker auparavant trois fréquences possibles parmi une fréquence centrale, une fréquence avec un décalage supérieur et une fréquence avec un décalage inférieur attribuées à chaque canal de diffusion en numérique prédéterminé ;
une étape de spécification d'un canal consistant à délivrer, lorsque l'utilisateur spécifie un canal demandé pour la réception à travers une opération de l'utilisateur selon une manière prédéterminée, des informations de spécification d'un canal qui indiquent le canal demandé ;
une étape de génération d'un signal de commande consistant à générer, sur la base desdites trois fréquences possibles attribuées au dit canal demandé dans ladite étape de stockage des données initiales pour un canal, un signal de commande qui ordonne une procédure de sélection d'un canal avec l'une quelconque desdites trois fréquences possibles attribuées au dit canal demandé ;
une étape de génération des informations de confirmation de synchronisation consistant à effectuer, sur la base dudit signal de commande généré, les opérations d'extraction et de démodulation en ce qui concerne les signaux d'onde numériques terrestres reçus par ladite antenne et à générer des informations de confirmation de synchronisation indiquant si ladite procédure de sélection d'un canal incluant les opérations de sélection et de démodulation est, ou non, terminée avec succès ; et
une étape de recherche consistant à rechercher, sur la base desdites informations de confirmation de synchronisation, une fréquence de diffusion utilisée réellement pour une diffusion en numérique parmi lesdites trois fréquences possibles attribuées au dit canal demandé.

22. Procédé de sélection d'un canal de réception qui doit être appliqué à un récepteur d'ondes pour la diffusion numérique terrestre (200) d'un type qui reçoit des signaux d'onde numériques terrestres modulés de manière numérique par une antenne et qui extrait parmi ceux-là, pour une démodulation, un signal d'onde numérique terrestre correspondant à un canal de diffusion en numérique spécifié par un utilisateur,
**caractérisé en ce que** le procédé comprend :
une étape de stockage des données initiales pour un canal consistant à stocker auparavant trois fréquences possibles parmi une fréquence centrale, une fréquence avec un décalage supérieur et une fréquence avec un décalage inférieur attribuées à chaque canal de diffusion en numérique prédéterminé ;
une étape de balayage de tous les canaux consistant à recevoir une instruction préétablie prédéterminée et, en réponse à celle-là, à délivrer séquentiellement, sur un canal de base, les informations de spécification d'un canal qui spécifient chacun d'une pluralité de canaux de diffusion en numérique prédéterminés ;
une première étape de génération d'un signal de commande consistant à générer, lors de la réception de ladite instruction préétablie, sur la base desdites trois fréquences possibles stockées auparavant attribuées à un canal spécifié attribué par chacune desdites informations de spécification d'un canal délivrées séquentiellement, un signal de commande ordonnant une procédure de sélection d'un canal avec l'une quelconque desdites trois fréquences possibles ;
une étape de génération des informations de confirmation de synchronisation consistant à effectuer, sur la base dudit signal de commande généré dans ladite étape de génération d'un premier signal de commande, les opérations d'extraction et de démodulation en ce qui concerne les signaux d'onde numériques terrestres reçus par ladite antenne et à générer des informations de confirmation de synchronisation indiquant si ladite procédure de sélection d'un canal incluant les opérations d'extraction et de démodulation est, ou non, terminée avec succès ;
une étape de recherche consistant à rechercher, sur la base desdites informations de confirmation de synchronisation, une fréquence de diffusion utilisée réellement pour une diffusion en numérique parmi lesdites trois fréquences possibles attribuées au dit canal spécifié ;
une étape de stockage consistant à stocker la fréquence de diffusion obtenue dans ladite étape de recherche dans un moyen de stockage non volatile prédéterminé conjointement avec ledit canal spécifié ;
une étape de spécification d'un canal consistant à délivrer des informations de spécification d'un canal indiquant un canal demandé en réponse au canal demandé par l'utilisateur pour une réception à travers l'opération de l'utilisateur selon une manière prédéterminée ;
une étape de lecture consistant à lire la fréquence de diffusion stockée dans ledit moyen de stockage non volatile conjointement avec ledit canal demandé lorsque lesdites informations de spécification d'un canal sont délivrées dans ladite étape de spécification d'un canal ;
une seconde étape de génération d'un signal de commande consistant à générer un signal de commande ordonnant une sélection d'un canal avec ladite fréquence lue depuis ledit moyen de stockage non volatile ; et
une étape de procédure de sélection d'un canal consistant à effectuer les opérations d'extraction et de démodulation en ce qui concerne les signaux d'onde numériques terrestres reçus par ladite antenne sur la base dudit signal de commande généré dans ladite seconde étape de génération d'un signal de commande.
